# EUROPEAN PATENT APPLICATION

(11) **EP 2 423 214 A1**
(43) Date of publication of application: **29.02.2012**
(21) Application number: 10172814.5
(22) Date of filing: 13.08.2010
(51) Int. Cl.: C07F 15/00, H01L 51/00

(54) **Light emitting materials for Electronics**

(71) Applicant: Solvay SA, 1050 Brussels (BE)
(72) Inventor: BARANOFF, Etienne David, RENENS VD, 1020 (CH); NAZEERUDDIN, Mohammad Khaja, 1024, ECUBLENS (CH); GRAETZEL, Michael, 1025, SAINT SULPICE (CH)
(74) Representative: Langfinger, Klaus Dieter

(57) **Abstract**

The present invention relates to an organometallic complex, to the preparation of said material, to the use of said material and to a light emitting device which transform electric energy into light.

The present invention is further related to provide phosphorescent complexes which contribute to extend the life time in operation of said OLEDs and especially when they are involved in the EL. The objectives of this invention are accomplished by iridium complex comprising 7-membered fused ring ligands which are tris-homoleptic or bis-homoleptic with an ancillary ligand.

## Description

### Technical field of the invention

This invention relates to an organic ligand, to a light emitting material made from said organic ligand, to the use of said light emitting material and to a light emitting device which transforms electric energy into light.

### Background of the invention

Opto-electronic devices involving organic materials have found increasing interest in the recent past for number or reasons. Many materials used in said devices are relatively inexpensive and modem chemical synthesis opens an access to a variety of organic molecules which carry potential interesting performances. In addition, their inherent properties such as flexibility or solubility make them well suited for flexible device manufacturing using a solution processing technology like printing.

Examples of actual opto-electronic devices include organic light emitting devices (OLEDs), organic transistors, organic photovoltaic cells and organic photo detectors and generally involve photo-luminescent materials.

The OLEDs are based on electroluminescence of organic materials. In contrast to photoluminescence, i.e. the light emission from an active material as a consequence of optical absorption and relaxation by radiative decay of an excited state, electroluminescence is a non-thermal generation of light resulting from the application of an electric field to a substrate. In this latter case, excitation is accomplished by recombination of charge carriers of contrary signs (electrons and holes) injected into an organic semiconductor in the presence of an external circuit .

A simple prototype of an organic light-emitting diode (OLED), i.e. a single layer OLED, is typically composed of a thin film of the active organic material which is sandwiched between two electrodes, one of which needs to be semitransparent in order to observe light emission from the organic layer. Generally an indium tin oxide (ITO)-coated glass substrate is used as anode.

If an external voltage is applied to the two electrodes, charge carriers, i.e. holes at the anode and electrons at the cathode, are injected to the organic layer beyond a specific threshold voltage depending on the organic material applied. In presence of an electric field, charge carriers move through the active layer and are non-radiatively discharged when they reach the opposite charged electrode. However, if a hole and an electron encounter one another while drifting through the organic layer, excited singlet (anti-symmetric) and triplet (symmetric) states, so-called excitons, are formed. Light is thus generated in the organic material from the decay of molecular excited states (or excitons). For every three triplet excitons that are formed by electrical excitation in an OLED, only one anti-symmetric state (singlet) exciton is created.

Many organic materials exhibit fluorescence (i.e. luminescence from a symmetry-allowed process) from singlet excitons; since this process occurs between states of like symmetry it may be very efficient. On the contrary, if the symmetry of an exciton is different from that of the ground state, then the radiative relaxation of the exciton is disallowed and luminescence will be slow and inefficient. Because the ground state is usually anti-symnetric, decay from a triplet breaks symmetry; the process is thus disallowed and efficiency of electroluminescence is very low. Thus the energy contained in the triplet states is mostly wasted and the maximum achievable theoretical quantum efficiency is only 25 % (where quantum efficiency refers to the efficiency with which holes and electrons recombine to produce luminescence).

Luminescence from a symmetry-disallowed process is known as phosphorescence. Characteristically, phosphorescence may persist for up to several seconds after excitation due to the low probability of the transition, in contrast to fluorescence, which decays rapidly due to the high probability of the transition.

Successful utilization of phosphorescent materials holds enormous promises for organic electroluminescent devices. For example, an advantage of utilizing phosphorescent materials is that all excitons (formed by combination of holes and electrons in electroluminescence), which are (in part) triplet-based in phosphorescent materials, can participate in energy transfer and luminescence.

Due to spin-orbit coupling that leads to singlet-triplet mixing, a number of heavy metal complexes display efficient phosphorescence from triplets at room temperature and OLEDs comprising such complexes have been shown to have internal quantum yields of more than 75 %.

In particular, certain organometallic iridium complexes exhibit intense phosphorescence and efficient OLEDs emitting in the red and green spectrum have been prepared with these complexes. As a mean for improving the properties of light-emitting devices, a green light-emitting device utilizing the emission from the ortho-metalated iridium complex Ir(ppy)₃ (tris-ortho-metalated complex of iridium (III) with 2-phenylpyridine) has been reported, see e.g. Appl. phys. lett.. 1999, vol.75, p.4.

The stability of OLEDs, in particular in term of lifetime, is still a challenge to make them attractive as alternative to actual lighting devices and also for other end-of-use applications. While improved materials and new manufacturing processes as well as encapsulation methods against degradation due to water and oxygen exposures are explored, the remaining intrinsic electroluminescence lost and voltage rise accompanying long term operating of the devices are still under study.

Various hypotheses have been promoted to explain the intrinsic efficiency degradation of the devices after extended operating time. The most widely accepted is the chemical degradation of the light-emissive molecules.

US application number 11/704,585 published as US2007/0190359 discloses phosphorescent iridium complexes bearing three identical, monoanionic, bidentate ligands formed by two aromatic rings bonded by a third one to form a central 6-membered ring. A variety of substituents is disclosed and used to tune the emission spectrum of said complexes.

US patent application number 12/265,375 published as US2009/0121624 discloses OLEDs wherein phosphorescent iridium complexes as disclosed in the previous reference US2007/0190359 hosted in 3,3'-bis(9-carbazolyl)-2,2'-biphenyl (mCBP) demonstrate extended life time compared to other disclosed benchmark devices wherein historical 4,4'-bis(9-carbazolyl)-2,2'-biphenyl (CBP) and/or Ir(ppy)₃ are involved instead of both first cited materials.

The phosphorescent metal complexes but also other materials constituting the electroluminescent layer of OLEDs are generally important regarding to their intrinsic performances and operating lifetime.

### Summary of the invention

It is thus a present objective of this invention to provide alternative organometallic complexes to be used as light emitting materials for optoelectronic devices such as OLEDs wherein said materials are used as dopant in an active layer. It is a further object of the invention to provide phosphorescent complexes which contribute to extend the lifetime in operation of said OLEDs and especially when they are involved in the emissive layer. It is further object of the invention to provide such phosphorescent complexes which are easily processable either by vacuum-processes or by solution processes.

These optoelectronic devices are achieved with the corresponding organometallic complexes of the present invention. Preferred embodiments are set forth in the sub-claims and in the following detailed specification.

### Brief description of drawings

FIG. 1 shows chemical structure, X-ray crystal structure and emission of CH₂Cl₂ solution of Comparative Compound 1 as reference.
FIG. 2 shows chemical structure, X-ray crystal structure and emission of CH₂Cl₂ solution of Compound 1 based on the invention formulation.
FIG. 3 shows IVL characteristics of the different devices prepared with Compound 1. Black: 1 % Compound 1, White: 5 % Compound 1, and Dot: 10 % Compound
FIG. 4 shows power efficiency of the different devices prepared with Compound 1 as a function of the luminance. Black: 1 % Compound 1, White: 5 % Compound 1, and Dot: 10 % Compound 1.
FIG. 5 shows chemical structure and emission of CH₂Cl₂ solution of Compound 2, Compound 3 and Compound 4.
FIG. 6 shows chemical structure and emission of CH₂Cl₂ solution of Compound 1, Compound 5 and Compound 6.
FIG. 7 shows chemical structure and emission of CH₂Cl₂ solution of Compound 2, Compound 4 and Compound 7.
FIG. 8 shows chemical structure and emission of CH₂Cl₂ solution of Compound 2 and Compound 8.
FIG. 9 shows chemical structure and emission of CH₂Cl₂ solution of Compound 5 and Compound 9.
FIG. 10 shows chemical structure, X-ray crystal structure and emission of CH₂Cl₂ solution of Compound 10.

### Description of illustrative embodiments

The invention will be described by detailed descriptions of several embodiments of the invention. It is clear that other embodiments of the invention can be configured according to the knowledge of persons skilled in the art without departing from the true spirit or technical teaching of the invention, the invention being limited only by the terms of the appended claims.

The present invention relates to a new family of ligands with design intrinsically leading to improve stability. The present invention also relates to tuning methods for these new ligands to obtain phosphorescent emitters with different emission spectra. The present invention relates also to light emitting materials containing the ligands described above and to light emitting devices containing those materials.

Development of phosphorescent emitters leading to devices with long lifetime is a challenge, more specifically for blue emitters. Blue phosphorescent emitters are used in display applications and in conjunction with complementary colors for white light emission and lighting applications.

The intrinsic instability of blue emitters is mainly due to a high energy content of the blue exciton, which brings the excited state significantly closer to a non-radiative state involving the rupture of an iridium-ligand bond.

As from the prior art, iridium complexes comprising ligands with 5-6 membered fused rings, emitting blue color, are already known. However, there is still a need to develop complexes, which are efficient and stable and at the same time easy to process.

The complexes of the prior art have a low efficiency due to the quenching of the radiative excited state. They are moreover relatively unstable as the Ir-N bond can be easily broken as shown below (a). If the correct re-coordination of the nitrogen giving back the original complex does not occur because of a rotation of the ligand, degradation products appear, which can further act as charge or exciton traps, decreasing further on the device performances.

To solve this problem, the rigidity of the ligand needs to be increased. Indeed, if free rotation is no more possible, the correct re-coordination of the nitrogen will be enhanced and the complex decomposition will be reduced. This has been achieved with 6-membered ring fused ligands. These ligands are completely flat and rigid and indeed lead to improvement of the device lifetime.

The ligands family shown below (b) can be considered as four fused rings or as a central 6-membered ring with three rings fused to it.

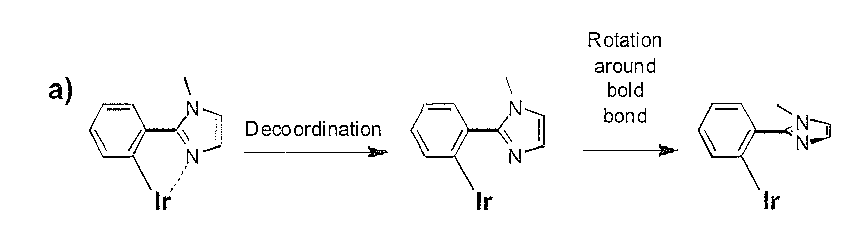

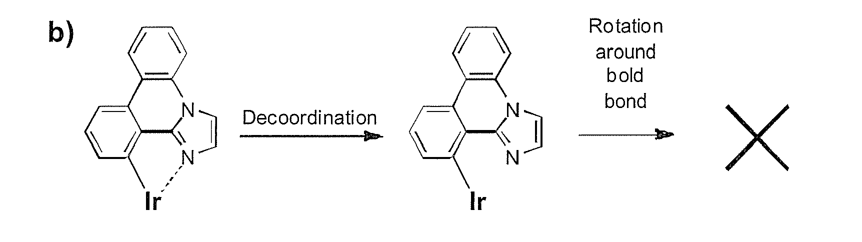

To improve the lifetime of phosphorescent devices, the inventors developed similar ligands while using a 7- or more membered central ring (formula (I)). The organometallic complexes of the present invention comprise these 7- or more membered fused ring ligands as in the following formula (I-0): 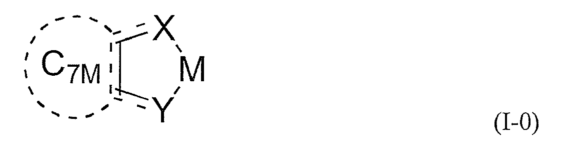 wherein M is a metal atom, preferably a transition metal having an atomic number of at least 20, preferably of at least 40, preferably of the groups 7 to 12, more preferably iridium or platinum, most preferably iridium; X and Y are atoms coordinated to M, preferably from the groups 13 to 16, more preferably from C, N, O, S, Si, or P, most preferably from C or N; C_{7M} is a seven or more membered ring (aromatic, non aromatic, partially aromatic, free of hetero atom or containing at least one hetero atom), not directly coordinated to M, that is no atom belonging to the seven member ring are directly coordinated to the metal center. The C_{7M} ring may be part of a larger ligand, such ligand being preferably a bidentate, tridentate, tetradentate, pentadentate or hexadentate ligand, more preferably a bidentate or tridentate, most preferably a bidentate ligand. Such larger ligand may contain additional fused ring.

In some embodiments, said organometallic complexes can be tris-homoleptic or bis-homoleptic with an ancillary ligand. Thus, the present invention relates to an organometallic complex comprising one metal atom **M** and at least one ligand **P*** represented by the formula (I) or formula (I') below: 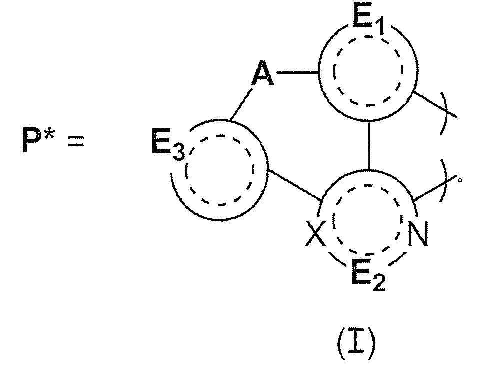 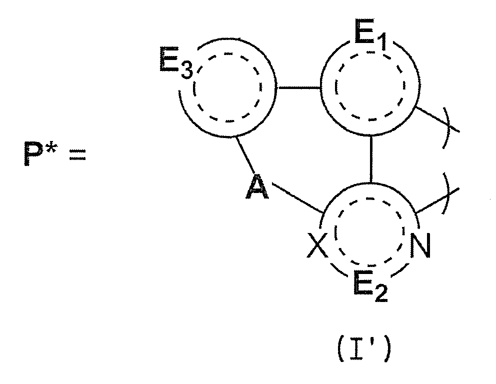 wherein:
- **E₁** represents an aromatic or heteroaromatic ring, preferably 5- or 6-membered, optionally condensed with an additional aromatic moiety or another non-aromatic cycle, said ring having optionally one or more substituents and coordinating M via a sp² hybridized carbon;
- **E₂** represents an aromatic or heteroaromatic ring, preferably comprising at least one nitrogen atom and optionally one or more additional hetero atom X, preferably 5-membered, optionally condensed with an additional aromatic moiety or another non-aromatic cycle, said ring having optionally one or more substituents and coordinating M via a sp² hybridized carbon or via a sp² hybridized nitrogen
- **E₃** represents an aromatic or heteroaromatic ring, preferably 5- or 6-membered, optionally condensed with additional aromatic moiety or other non-aromatic cycle, said ring having optionally one or more substituents;
- **A** represents an organic or hetero organic bridging group, formed by at least one atom bonding **E₁** with **E₃** or **E₂** with **E₃,** and forming with **E₁, E₂** and **E₃** a central ring, said central ring is 7- or more membered, preferably 7- to 9-membered, more preferably 7-membered.

In specific embodiments, **E₁, E₂** and **E₃** are an aromatic or heteroaromatic ring having two to thirty carbon atoms, which are optionally substituted by at least one substituent **R** wherein **R** is the same or different at each occurrence and is H, -F, -Cl, -Br, -I, -NO₂ -CN, -OH, a straight-chain or branched or cyclic alkyl group having from 1 to 50 carbon atoms, each of which one or more adjacent or nonadjacent hydrocarbon group may be replaced by -O-, -S-, -CR¹R²-, -S(=O)-, - S(=O)₂⁻, -SiR¹R²-, -GeR¹R²-, -NR¹-, -BR¹-, -PR¹-, -P(=O)R¹-, -P(=O)OR¹-, - C(=O)-, -C(=S)-, -C(=R¹R²)-, -CR¹=CR²-, -C=C-, -C(=O)O-, -OC(=O)-, - C(=NR¹)-, -C=NR¹-, -NR¹C(=O)-, -C(=O)NR¹-, -NR¹C(=S)- or -C(=S)NR¹-, and in each of which one or more hydrogen atoms may be replaced by F, -Cl, - Br, -I, -NO₂, -CN, -OH, -C(=O)OR¹, -OC(=O)R¹, a straight-chain or branched or cyclic alkyl, alkoxy, amine, phosphine, phosphite, phosphonite, silane, gennane, borane, borate, boronate, sulfane, sulfinyl, sulfonyl group, an aryl, heteroaryl, alkanyl, alkenyl, alkynyl group which may be substituted by one or more non aromatic radicals, wherein a plurality of **R**, either on the same ring or on two different rings, may in turn together form a mono- or polycyclic ring, optionally aromatic, optionally containing one or more heteroatoms; wherein R¹ and R² are the same or different at each occurrence and are H, -F, -Cl, -Br, -I, -NO₂, -CN, - OH, a straight-chain or branched or cyclic alkyl group having from 1 to 50 carbon atoms, each of which one or more adjacent or nonadjacent hydrocarbon group may be replaced by -O-, -S-, -CR³R⁴-, -S(=O)-, -S(=O)₂-, - SiR³R⁴-, -GeR³R⁴-, -NR³-, -BR³-, -PR³-, -P(=O)R³-, -P(=O)OR³-, -C(=O)-, - C(=S)-, -C(=R³R⁴)-, -CR³=CR⁴-, -C≡C-, -C(≡O)O-, -OC(=O)-, -C(=NR³)-, - C=NR³-, -NR³C(=O)-, -C(=O)NR³-, -NR³C(=S)- or -C(=S)NR³-, and in each of which one or more hydrogen atoms may be replaced by F, -Cl, -Br, -I, -NO₂, - CN, -OH, -C(=O)OR³, -OC(=O)R³, a straight-chain or branched or cyclic alkyl, alkoxy, amine, phosphine, phosphite, phosphonite, silane, germane, borane, borate, boronate, sulfane, sulfinyl, sulfonyl group, an aryl, heteroaryl, alkanyl, alkenyl, alkynyl group which may be substituted by one or more non aromatic radicals, wherein a plurality of **R**, either on the same ring or on two different rings, may in turn together form a mono- or polycyclic ring, optionally aromatic, optionally containing an heteroatom; wherein each **R³** and **R⁴** are the same or different at each occurrence and are independently selected from hydrogen, halo, alkyl, alkenyl, alkynyl, heteroalkyl, aryl, heteroaryl.

In other embodiments, **E₁**, **E₂** and **E₃** are selected from carbanion cycles, neutral cycles and multi fused rings. For instance, in formula (I'), **E1** and **E3** can be part of a fluorene, carbazole, dibenzothiophene, dibenzothiophene 5,5-dioxide, dibenzoborole, benzophosphindole, benzophosphindole 5 oxide or dibenzosilacyclopentane moiety.

In some preferred embodiments, the organometallic complex of the present invention, the bidentate ligand **P*** is represented by one of the formulas (II) to (VI") below: 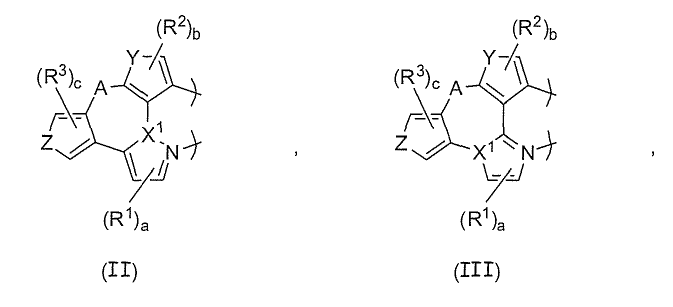 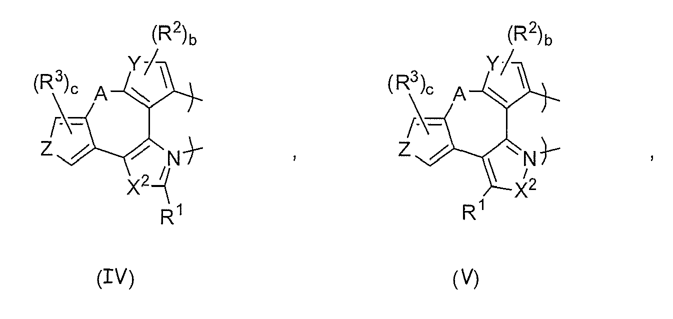 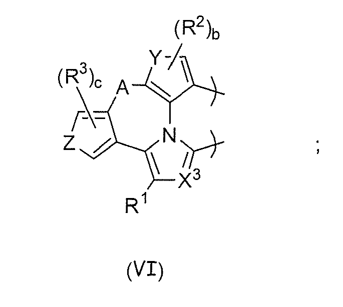 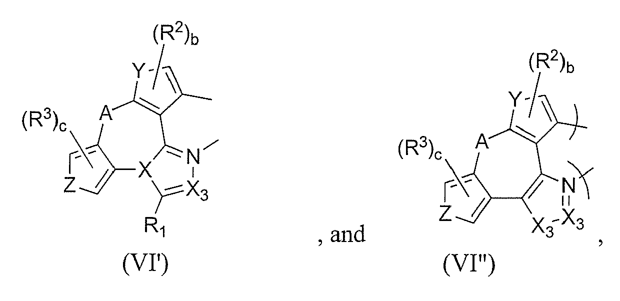 wherein:
- **A** has the same meaning as defined above;
- **X¹** is C or N, preferably **X¹** is N;
- **X²** is selected from the group consisting of C-H, C-R', N-H and N-R, preferably **X²** is N-H or N-R, more preferably **X²** is N-R;
- **X³** is **selected** from the group consisting ofN, N-H and N-R', preferably **X³** is N-R;
- **Y** and **Z** are the same or different at each occurrence and are selected from the group consisting of O, S, Se, N-H, N-R, -CH=CH-, -CR'=CH-, -CR'=CR'-, CR'=N-, preferably **Y** and **Z** are selected from the group consisting of CH=CH-, -CR'=CH-, -CR'=CR'-, -CH=N- or -CR'=N
- **R** is the same or different at each occurrence and is selected from the group consisting of straight or branched alkyl having from 1 to 20 carbon atoms, cyclic alkyl having from 3 to 20 carbon atoms, straight or branched heteroalkyl having from 1 to 20 carbon atoms, aryl having from 4 to 14 carbon atoms, heteroaryl having from 4 to 14 carbon atoms that may be substituted by one or more non aromatic radicals;
- **R¹, R²**, **R³** and **R'** are the **same** or different at each occurrence and is selected from the group consisting of -H, -F, -Cl, -Br, -CN, -NO₂, -CF₃, straight or branched alkyl having from 1 to 20 carbon atoms, cyclic alkyl having from 3 to 20 carbon atoms, straight or branched heteroalkyl having from 1 to 20 carbon atoms, aryl having from 4 to 14 carbon atoms, heteroaryl having from 4 to 14 carbon atoms that may be substituted by one or more non aromatic radicals; **R¹**, **R²**, **R³** and **R'** can form additional fused ring system with the ring moiety on which they are grafted and/or with the bridging group **A.**
- **a** and **c** are the same or different at each occurrence and represent an integer from 0 to 2;
- **b** represents an integer from 0 to 1.

In some preferred embodiments, the metal **M** is a transition metal from the group IB, IIB, IIIB, IVB, VB, VIB, VIIB or VIII, preferably from the group VIII, more preferably Os, Ir or Pt.

In some preferred embodiments, the bridge **A** is selected from the group consisting of O, S, Se, C=O 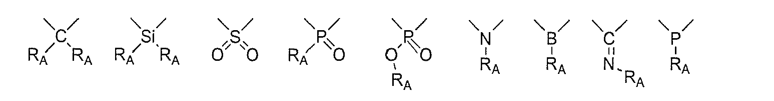 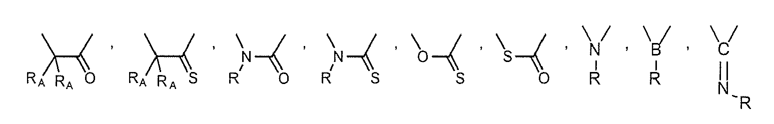 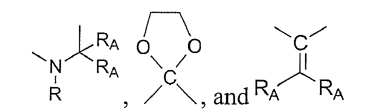 wherein
- **R** has the same meaning as defined above for formulae (I) and (I'), **R** can form additional fused ring system with a neighboring ring moiety;
- **R_{A}** is the same or different at each occurrence and is selected from the group consisting of -H, -F, -Cl, -Br, -CN, NO₂, straight or branched alkyl having from 1 to 20 carbon atoms, cyclic alkyl having from 1 to 20 carbon atoms, aryl having from 4 to 14 carbon atoms, straight or branched heteroalkyl having from 1 to 20 carbon atoms which may be substituted by one or more non aromatic radicals, preferably **R_{A}** is selected from the group of alkyl or aryl having from 1 to 6 carbon atoms; more preferably **R_{A}** is selected from the group of methyl, ethyl, n-propyl, i-propyl, n-butyl, cycloalkyl or polycycloalkyl, **R_{A}** can form additional fused ring system with a neighboring ring moiety;
a straight or branched alkyl having from 1 to 20 carbon atoms, a cyclic alkyl having from 1 to 20 carbon atoms, an aryl having from 4 to 14 carbon atoms, straight or branched heteroalkyl having from 1 to 20 carbon atoms which may be substituted by one or more non aromatic radicals.

Preferably A is selected from the group consisting of O, S, Se,

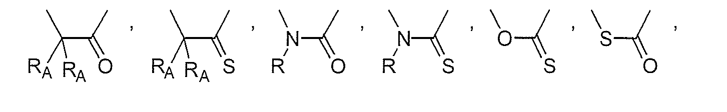

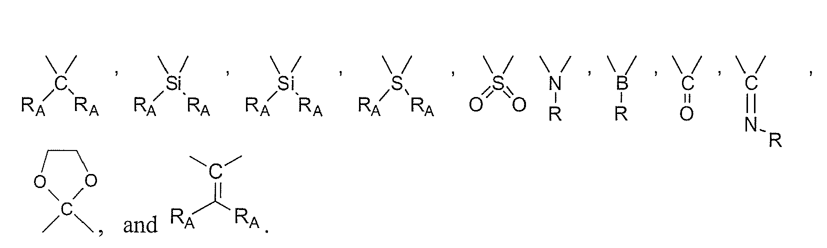

More preferably **A** is selected from the group consisting of O, S, -N-H, -N-R, C(CH₃)₂, C=C(H)R or C=O.

In a preferred embodiment, the organometallic complex is bis-homoleptic and comprises two bidentate principal ligands **P*** as defined above and one ancillary ligand wherein said ligand is a bidentate ancillary ligand, preferably aceto acetonate type or picolinate type, more preferably aceto acetonate type.

In a more preferred embodiment, the organometallic complex is represented by the formula (VII) below: 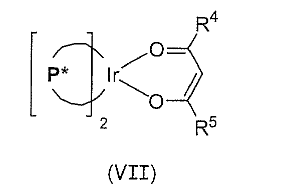 wherein:
- **P*** has the same meaning as defined above;
- **R⁴** and **R⁵** are the same or different at each occurrence and are independently selected from the group consisting of straight or branched alkyl having from 1 to 20 carbon atoms, cyclic alkyl having from 1 to 20 carbon atoms, aryl having from 4 to 14 carbon atoms, straight or branched hetero alkyl having from 1 to 20 carbon atoms which may be substituted by one or more non aromatic radicals, preferably **R⁴** and **R⁵** are independently selected from the group of alkyl or aryl having from 1 to 6 carbon atoms; more preferably **R⁴** and **R⁵** are selected from the groups of methyl, ethyl, n-propyl, i-propyl, n-butyl, cycloalkyl and polycycloalkyl.

In another preferred embodiment, the organometallic complex corresponds to one of the formulas (VIII) to (XII") below:

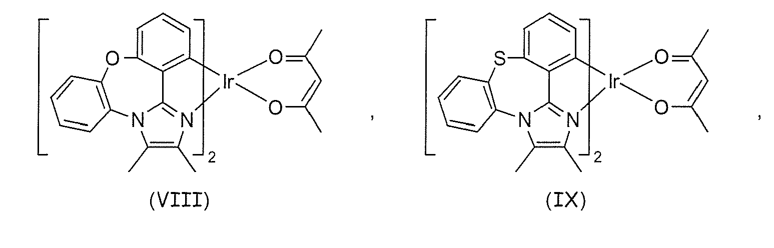

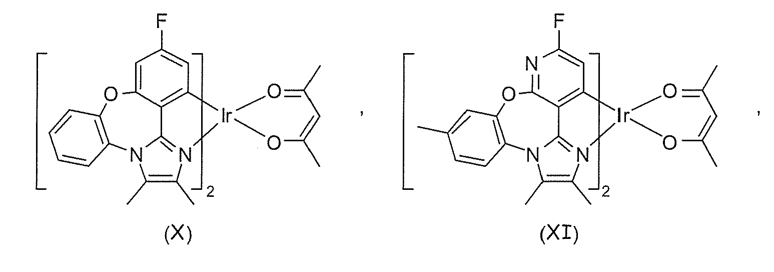

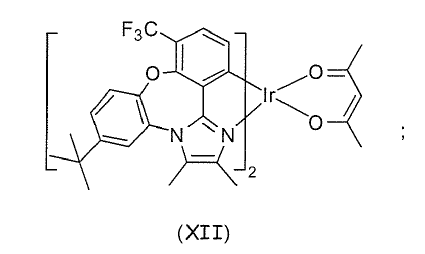

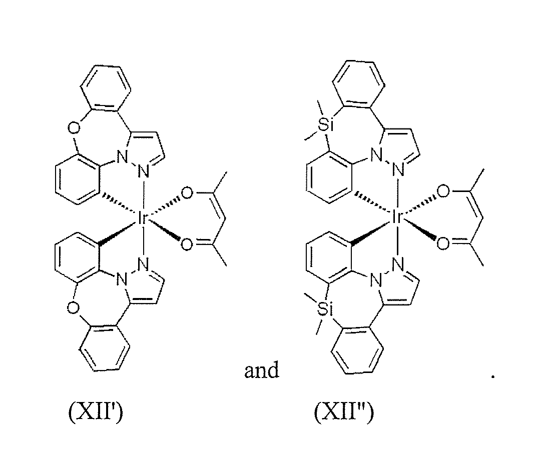

In the most preferred embodiment, the organometallic complex is tris-homoleptic and comprises three bidentate ligands **P*** as defined above.

More specifically, the organometallic complex corresponds to one of the formulas (XIII) to (XVI) below: 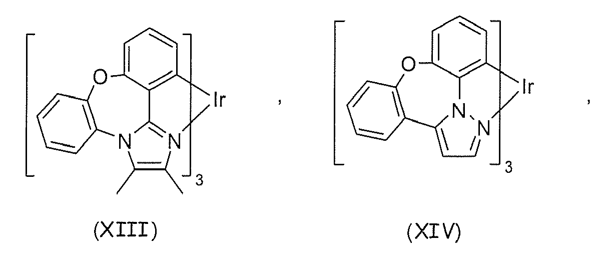 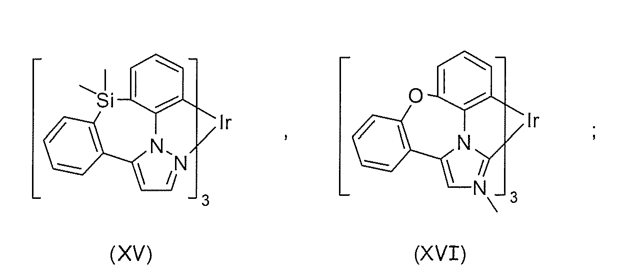 preferably

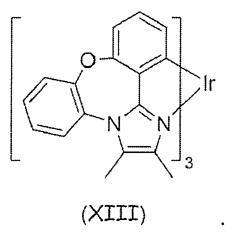

According to one embodiment, the organometallic complex of the invention contains at least one ligand **P*** which is represented by the formula (I). According to another embodiment, the ligand **P*** is represented by the formula (I').

In a specific embodiment, organometallic complex according to formula (I') can comprise the organic or hetero organic bridging group A formed by at least one atom bonding E₂ and E₃.

In a more specific embodiment, above organometallic complex may correspond to formula (XVII) below: 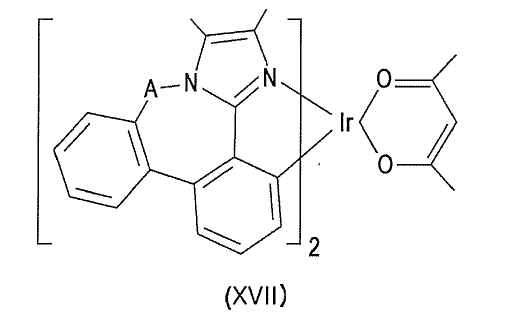 wherein, A is the same as defined above.

In a more specific embodiment, above organometallic complex may correspond to formula (XVIII) below:

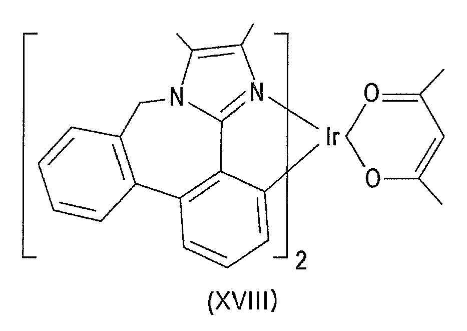

The use of organometallic complex according to the present invention as light emitting material or dopant in the emissive layer of an OLED is also comprised in the scope of the present invention.

In a preferred embodiment, the organometallic complex according to the present invention is used as a phosphorescent light emitting material in the emissive layer of an OLED.

### Examples

Comparative compound 1 (named es43 in the relevant patent:
WO 2008/156869) as a sky-blue benchmark molecule was prepared as reference.

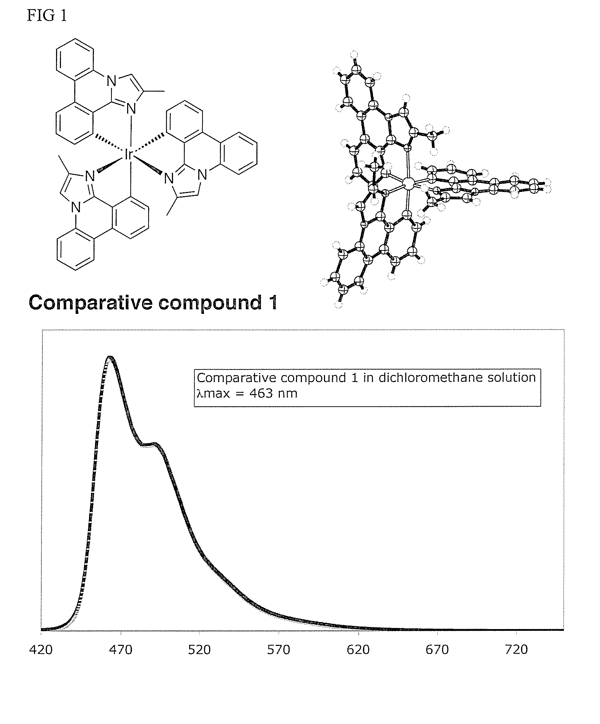

FIG. 1 shows chemical structure, X-ray crystal structure and emission of CH₂Cl₂ solution of Comparative compound 1. Comparative compound 1 has bright sky-blue emission, but low solubility in common organic solvents and O₂ and light instability.

### Synthesis

### Example 1 - Preparation of Compound 1 (EB234)

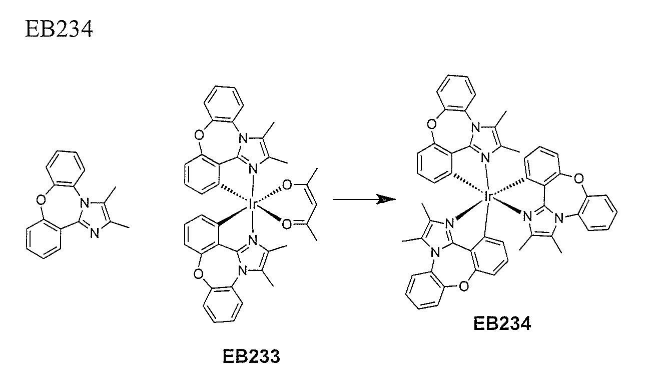

Argon was bubbled into a solution of 2,3-dimethyldibenzo[b,f]imidazo[1,2-d][1,4]oxazepine (60 mg, 0.23 mmol) in glycerol (60 mL) at 80 °C for 1 hour. EB233 (140 mg, 0.17 mmol) was added as a solid and the suspension heated at 200 °C for 20 hours under argon. After cooling down to room temperature, the solution was diluted with water and extracted with dichloromethane. The organic phase was passed through a pad of silica gel eluting with dichloromethane. The volume of the solution obtained was reduced to about 15 mL and diethyl ether was added. After leaving in the fridge for 4 hours, the solid was filtrated, washed with Et₂O and dried. EB234 was obtained as a yellow solid (87 mg, yield 52 %).

¹H NMR (CDCl₃, 400 MHz): d 7.37 (dd, J= 8.0,1.2 Hz, 3H); 7.23 (ddd, J= 8.0, 7.2,1.6 Hz, 3H); 7.14 (dt, J= 8.0, 1.2 Hz, 3H); 7.10 (dd, J= 8.0, 1.6 Hz, 3H); 6.74 (t, J= 8.0 Hz, 3H); 6.61 (dd, J= 8.0, 0.8 Hz, 3H); 6.42 (dd, J= 8.0, 0.8 Hz, 3H); 2.28 (s, 9 H); 1.59 (s, 9H).

### Example 2 - Preparation of Compound 2 (EB233)

### dibenzo[b,f][1,4]oxazepine

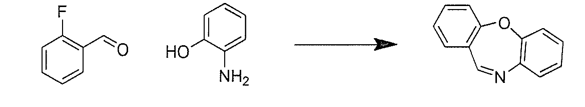

To a solution of 2-aminophenol (4.84 g, 44.3 mmol) in DMF (85 mL) was added 2-fluorobenzaldehyde (5 g, 40.3 mmol) and K₂CO₃ (5.57 g, 40.4 mmol). The mixture was heated at 100 °C for 20 hours. After cooling down to room temperature, water was added and extracted with diethyl ether. The organic phase was washed with water and brine and dried over MgSO₄. After removal of volatiles under vacuum, the crude is purified by column chromatography on silica gel using CH₂Cl₂/Et₂O as eluent. The compound is obtained as a light brown soft solid (4.3 g, yield 55%).

¹H NMR (CDCl₃, 400 MHz): δ 8.53 (s, 1H); 7.45 (dt, J= 8.0, 1.6 Hz, 1H); 7.37 (dd, J= 7.6, 2.0 Hz, 1 H); 7.34 (dd, J= 8.0, 2.0 Hz, 1H); 7.25-7.09 (m, 5H).

### 2,3-dimethyldibenzo[b,f]imidazo[1,2-d][1,4]oxazepine:

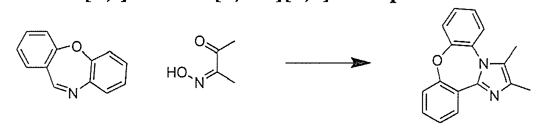

A solution of dibenzo[b,f][1,4]oxazepine (2.58 g, 13.2 mmol) and 2,3-butanedione monoxime (1.34 g, 13.2 mmol) in acetic acid (100 mL) was refluxed at 120 °C for 4 hours. After cooling down at room temperature, zinc powder (2 grams) was added and the mixture further refluxed at 120 °C for 1 hour and left at room temperature overnight. The suspension is then filtered and filtrate is reduced to about 20 mL. Water was added (about 100 mL) and aqueous KOH was added up to pH ~ 8. The mixture was extracted with dichloromethane and the crude obtained purified by column chromatography using CH₂Cl₂/Et₂O as eluent. The ligand was obtained as a brown waxy solid (3.28 g, yield 94 %)

¹H NMR (CDCl₃, 400 MHz): δ 7.94 (dd, J= 7.6, 2.0 Hz, 1H); 7.41 (dd,

J= 8.0, 1.6 Hz, 1H); 7.38-7.18 (m, 6H); 2.34 (s, 3H); 2.33 (s, 3H).

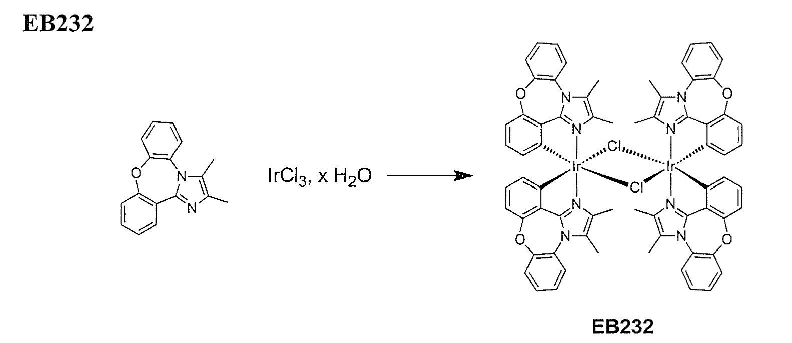

A mixture of IrCl₃, x H₂O (610 mg, 1.73 mmol) and 2,3-dimethyldibenzo[b,f]imidazo[1,2-d][1,4]oxazepine (1 g, 3.8 mmol) in water/Ethoxyethanol was heated at 130 °C for 18 hours under argon. After cooling down to room temperature, the mixture is poured into water and the precipitate filtered and washed thoroughly with water and finally with cold methanol (40 mL). **EB232** was obtained as a dark yellow solid (863 mg, yield 66 %).

¹H NMR (CDCl₃, 400 MHz): δ 7.46 (m, 4H); 7.36-7.28 (m, 12 H); 6.59 (t, J= 8 Hz, 4H); 6.47 (d, J= 7.2 Hz, 4H); 6.13 (d, J= 7.2 Hz, 4H); 2.64 (s, 12H); 2.17 (s, 12 H).

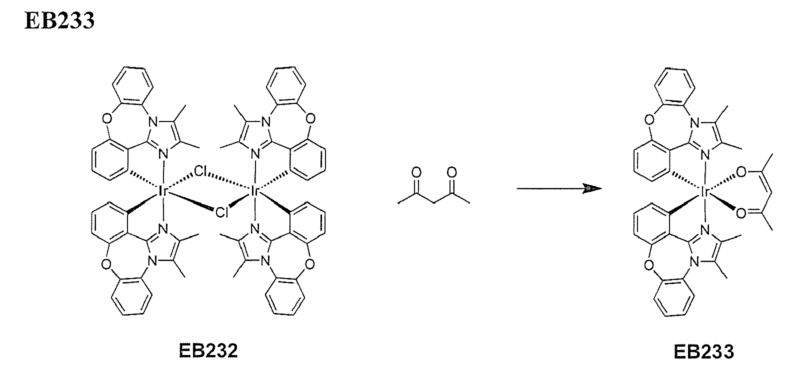

To a solution of **EB232** (400 mg, 0.26 mmol) in dichloromethane (80 mL) was added acetylacetone (100 mg, 1 mmol) and tetrabutyl ammonium hydroxide (600 mg, 0.75 mmol). The solution was heated at 40 °C for 12 hours under argon. After cooling down to room temperature, the solution was washed with water and the organic phase was passed through a pad of silica gel eluting with dichloromethane. **EB233** was obtained as a yellow solid (386 mg, yield 89 %).

¹H NMR (CDCl₃, 400 MHz): δ 7.35 (dd, J= 8.0, 2.0 Hz, 2H); 7.32 (dd, J= 8.0, 2.0 Hz, 2H); 7.26 (dt, J= 7.6, 2.0 Hz, 2H); 7.22 (dt, J= 7.6, 1.6 Hz, 2H); 6.65 (t, J= 8.0 Hz, 2H); 6.51 (dd, J= 8.0, 0.8 Hz, 2H); 6.22 (dd, J= 7.2, 0.8 Hz, 2H); 5.30 (s, 1H); 2.53 (s, 6H); 2.23 (s, 6H); 1.77 (s, 6H).

Preparation of Compound 3 **(EB238)**

### 8-(tert-butyl)-4-(trifluoromethyl)dibenzo [b,f] [l,4] oxazepine

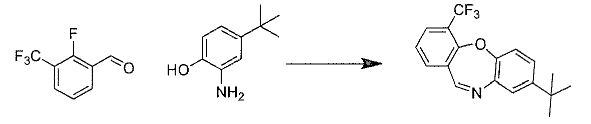

To a solution of 2-amino-4-tert-butyl-phenol (2.4 g, 14.5 mmol) in DMF (45 mL) was added 2-fluoro-3-(trifluoromethyl)benzaldehyde (2.5 g, 13.0 mmol) and K₂CO₃ (3.5 g, 25.3 mmol). The mixture was heated at 100 °C for 20 hours. After cooling down to room temperature, water was added and extracted with diethyl ether. The organic phase was washed with water and brine and dried over MgSO₄. After removal of volatiles under vacuum, the crude is purified by column chromatography on silica gel using CH₂Cl₂/MeOH as eluent. The compound is obtained as a brown wax (3.2 g, yield 77%).

¹H NMR (CDCl₃, 400 MHz): δ 8.5 (s, 1H); 7.72 (dd, J= 7.6, 0.8 Hz, 1H); 7.52 (dd, J= 8.0, 1.6 Hz, 1H); 7.39 (d, J= 2.4 Hz, 1H); 7.28 (m, 2H); 7.14 (dd, J= 8.4, 0.8 Hz, 1 H); 1.31 (s, 9H).

### 6-(tert-butyl)-2,3-dimethyl-10-(trifluoromethyl)dibenzo[b,f]imidazo[1,2-d][1,4]oxazepine

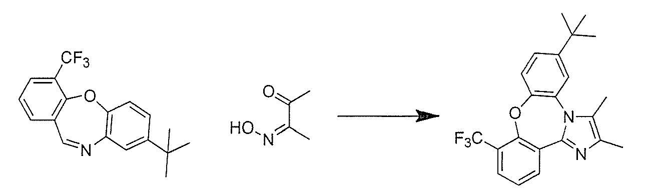

A solution of 8-(tert-butyl)-4-(trifluoromethyl)dibenzo[b,f][1,4]oxazepine (1.99 g, 6.23 mmol) and 2,3-butanedione monoxime (630 mg, 6.23 mmol) in acetic acid (60 mL) was refluxed at 120 °C for 2 hours. After cooling down at room temperature, zinc powder (2 grams) was added and the mixture further refluxed at 120 °C for 1 hour and left at room temperature overnight. The suspension is then filtered and filtrate is reduced to about 20 mL. Water was added (about 100 mL) and aqueous KOH was added up to pH ~ 8. The mixture was extracted with dichloromethane and the crude obtained purified by column chromatography using CH₂Cl₂/MeOH as eluent. The ligand was obtained as a brown waxy solid (2.35 g, yield 97 %)

¹H NMR (CDCl₃, 400 MHz): δ 8.16 (dd, J= 8.0, 1.6 Hz, 1H); 7.63 (dd, J= 8.0, 1.6 Hz, 1H); 7.44 (dd, J= 8.8, 0.8 Hz, 1H); 7.34 (dd, J= 8.4, 2.4 Hz, 1 H); 7.31 (t, J= 8.0 Hz, 1H); 7.28 (d, J= 2.4 Hz, 1H); 2.36 (s, 3H); 2.33 (s, 3H); 1.31 (s, 9H).

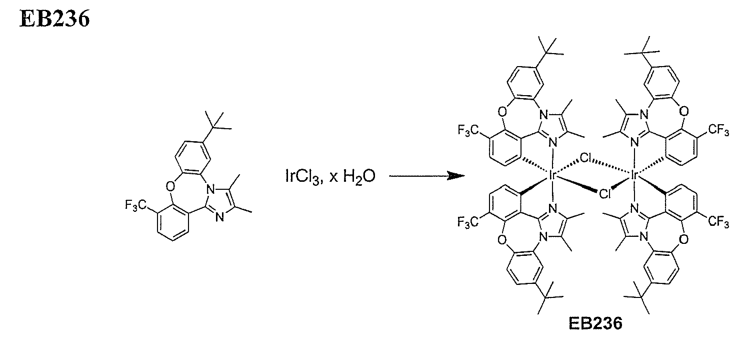

A mixture of IrCl₃, x H₂O (620 mg, 1.76 mmol) and 6-(tert-butyl)-2,3-dimethyl-10-(trifluoromethyl)dibenzo[b,f]imidazo[1,2-d][1,4]oxazepine (1.5 g, 3.88 mmol) in water/Ethoxyethanol was heated at 130 °C for 18 hours under argon. After cooling down to room temperature, the mixture is poured into water and the precipitate filtered and washed thoroughly with water and finally with cold methanol (40 mL). **EB236** was obtained as a yellow solid (948 mg, yield 54 %).

¹H NMR (CDCl₃, 400 MHz): δ 7.36 (m, 12H); 6.85 (d, J= 8.0 Hz, 4H); 6.18 (d, J= 8.0 Hz, 4H); 2.69 (s, 12H); 2.11 (s, 12H); 1.40 (s, 36H).

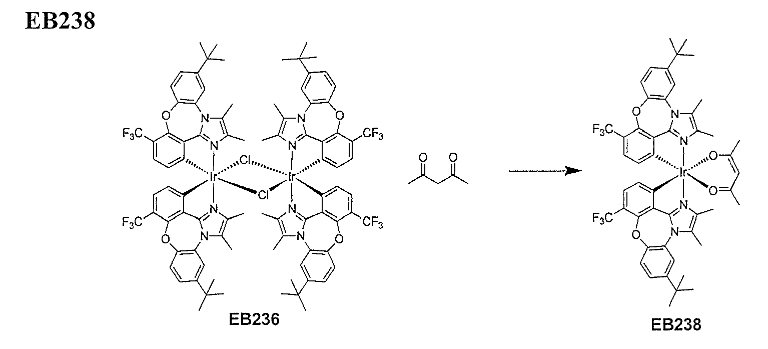

To a solution **of EB236** (330 mg, 0.16 mmol) in dichloromethane (150 mL) was added acetylacetone (300 mg, 3 mmol) and tetrabutyl ammonium hydroxide (500 mg, 0.62 mmol). The solution was heated at 40 °C for 12 hours under argon. After cooling down to room temperature, the solution was washed with water and the organic phase was passed through a pad of silica gel eluting with dichloromethane/hexane. **EB238** was obtained as a yellow solid (259 mg, yield 76 %).

¹H NMR (CDCl₃, 400 MHz): δ 7.36 (d, J= 8.4 Hz, 2H); 7.30 (dd, J= 8.4, 2.4 Hz, 2H); 7.27 (d, J= 2.4 Hz, 2H); 6.86 (d, J= 8.0 Hz, 2H); 6.27 (d, J= 8.0 Hz, 2H); 5.31 (s, 1H); 2.53 (s, 6H); 2.21 (s, 6H); 1.77 (s, 6H); 1.34 (s, 18H).

### Example 4 - Preparation of Compound 4 (EB241)

### 3-fluorodibenzo[b,f][1,4]oxazepine

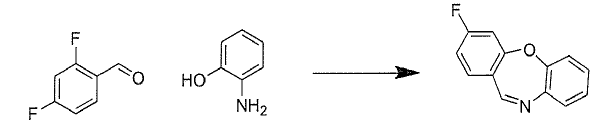

To a solution of 2-amino-phenol (2.3 g, 21.1 mmol) in DMF (45 mL) was added 2,4-difluoro-benzaldehyde (3 g, 21.1 mmol) and K₂CO₃ (3.5 g, 25.3 mmol). The mixture was heated at 100 °C for 20 hours. After cooling down to room temperature, water was added and extracted with dichloromethane. The organic phase was washed with water and brine and dried over MgSO₄. After removal of volatiles under vacuum, the crude is used directly in the next reaction.

### 11-fluoro-2,3-dimethyldibenzo[b,f]imidazo[1,2-d][1,4]oxazepine

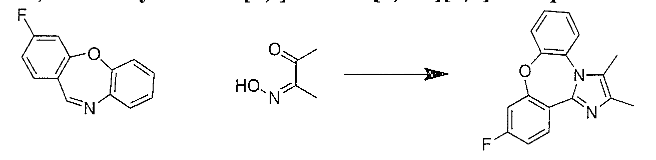

A solution of 3-fluorodibenzo[b,f][1,4]oxazepine (previous crude) and 2,3-butanedione monoxime (2.1 g, 20.7 mmol) in acetic acid (120 mL) was refluxed at 90 °C for 2 hours. After cooling down at room temperature, zinc powder (2 grams) was added and the mixture further refluxed at 120 °C for 1 hour and left at room temperature overnight. The suspension is then filtered and filtrate is reduced to about 20 mL. Water was added (about 100 mL) and aqueous KOH was added up to pH ~ 8. The mixture was extracted with dichloromethane and the crude obtained purified by column chromatography using CH₂Cl₂/MeOH as eluent. The ligand was obtained as a brown waxy solid (712 mg, yield 12 %)

¹H NMR (CDCl₃, 400 MHz): δ 7.91 (dd, J= 8.8, 6.4 Hz, 1H); 7.38 (dd, J= 8.0, 1.6 Hz, 1H); 7.33-7.20 (m, 3H); 6.96 (m, 2H); 2.32 (s, 3H); 2.31 (s, 3H).

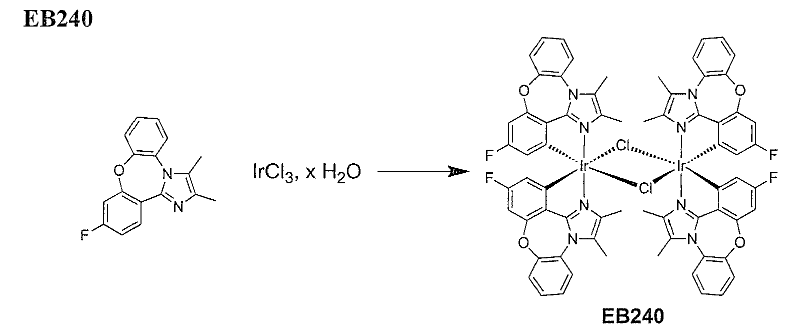

A mixture of IrCl₃, x H₂O (285 mg, 0.81 mmol) and 11-fluoro-2,3 dimethyldibenzo[b,f]imidazo[1,2-d][1,4]oxazepine (500 mg, 1.78 mmol) in water/Ethoxyethanol was heated at 130 °C for 18 hours under argon. After cooling down to room temperature, the mixture is poured into water and the precipitate filtered and washed thoroughly with water and finally with cold methanol (40 mL). **EB240** was obtained as a brown solid not further purified nor identified (302 mg of solid assumed to be the dimer).

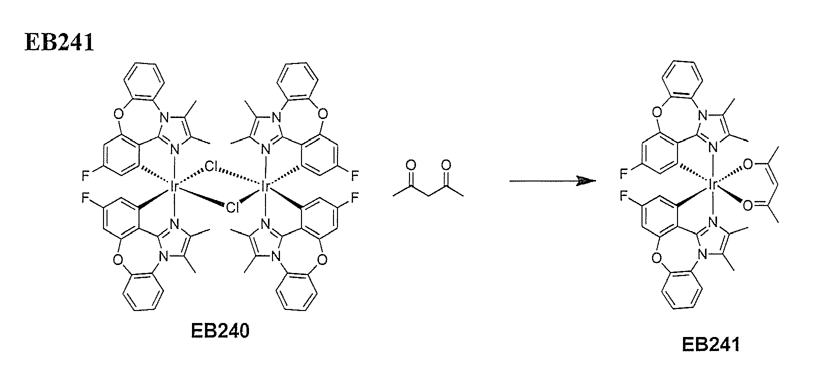

To a solution **of EB240** in dichloromethane (150 mL) was added acetylacetone (300 mg, 3 mmol) and tetrabutyl ammonium hydroxide (500 mg, 0.62 mmol). The solution was heated at 40 °C for 12 hours under argon. After cooling down to room temperature, the solution was washed with water and the organic phase was passed through a pad of silica gel eluting with dichloromethane/hexane. **EB241** was obtained as a yellow solid (48 mg).

¹H NMR (CDCl₃, 400 MHz): δ 7.33-7.19 (m, 8H); 6.30 (dd, J= 12.0, 2.4 Hz, 2H); 5.86 (dd, J= 11.6, 2.0 Hz, 2H); 5.29 (s, 1H); 2.49 (d, J= 0.8 Hz, 6H); 2.17 (d, J= 0.8 Hz, 6H); 1.76 (s, 6H).

### Example 5 - Preparation of Compound 5 (EB245)

### 2-(1-(2-fluorophenyl)-1H-pyrazol-5-yl)phenol

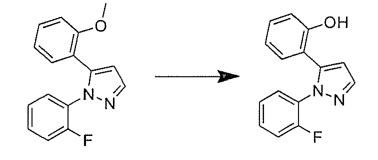

1-(2-fluorophenyl)-5-(2-methoxyphenyl)-1*H*-pyrazole (1 g, 3.72 mmol) and freshly prepared pyridinium chloride (4 grams) are intimately mixed and the mixture heated 4 times 1 minute at 600 W with microwave. After cooling down to room temperature, water was added and the white precipitate filtered, washed with water and dried (936 mg, yield 98 %).

¹H NMR (CDCl₃, 400 MHz): δ 7.86 (d, J= 2.0 Hz, 1H); 7.43 (dt, J= 7.6, 1.6 Hz, 1H); 7.32 (m, 1H); 7.19 (m, 2H); 7.05 (ddd, J= 9.6, 8.4, 1.2 Hz, 1H); 6.93 (dd, J= 8.4, 1.2 Hz, 1H); 6.89 (dd, J= 8.0, 1.6 Hz, 1H); 6.76 (dt, J= 7.6, 1.2 Hz, 1H); 6.61 (d, J= 1.6 Hz, 1H).

### dibenzo[b,f]pyrazolo[1,5-d][1,4]oxazepine

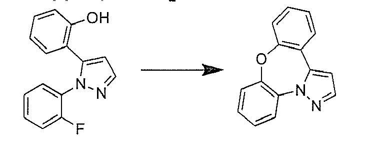

A mixture of 2-(1-(2-fluorophenyl)-1H-pyrazol-5-yl)phenol (900 mg, 3.52 mmol) and K₂CO₃ (2 grams) in DMF (50 mL) was heated at 90 °C for 12 hours. After cooling to room temperature, water was added and the precipitate filtered off, washed with water and dried. The crude was filtered on a pad of silica gel using dichloromethane as eluent. The product was obtained as a white solid (766 mg, yield 92 %).

¹H NMR (CDCl₃, 400 MHz): δ 7.86 (m, 1H); 7.79 (d, J= 2.0 Hz, 1H); 7.55 (dd, J= 8.0, 1.6 Hz, 1H); 7.41-7.20 (m, 6H); 6.66 (d, J= 2.0 Hz, 1H).

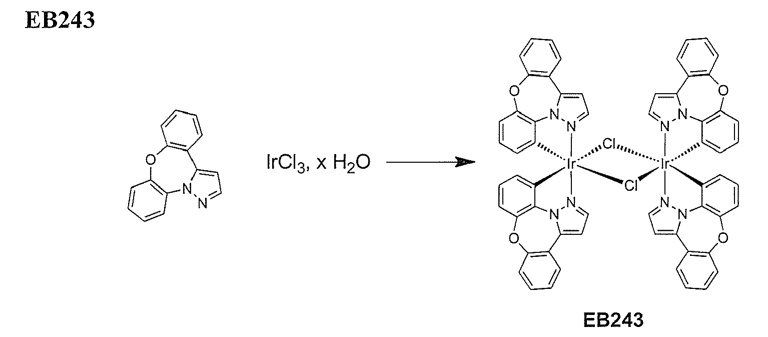

A mixture of IrCl₃, x H₂O (225 mg, 0.64 mmol) and dibenzo[*b,f*]pyrazolo[1,5-*d*][1,4]oxazepine (330 mg, 1.4 mmol) in water/Ethoxyethanol was heated at 130 °C for 18 hours under argon. After cooling down to room temperature, the mixture is poured into water and the precipitate filtered and washed thoroughly with water and finally with cold methanol (40 mL). **EB243** was obtained as a greenish yellow solid (430 mg, yield 96 %).

¹H NMR (CDCl₃, 400 MHz): δ 8.04 (d, J= 2.4 Hz, 4H); 7.63 (dd, J= 8.0, 1:6 Hz, 4H); 7.36 (dt, J= 8.0, 1.6 Hz, 4H); 7.23 (m, 8H); 6.90 (d, J= 2.4 Hz, 4H); 6.59 (dd, J= 8.0, 1.6 Hz, 4H); 6.55 (t, J= 8.0 Hz, 4H); 5.77 (dd, J= 7.2, 1.6 Hz, 4H).

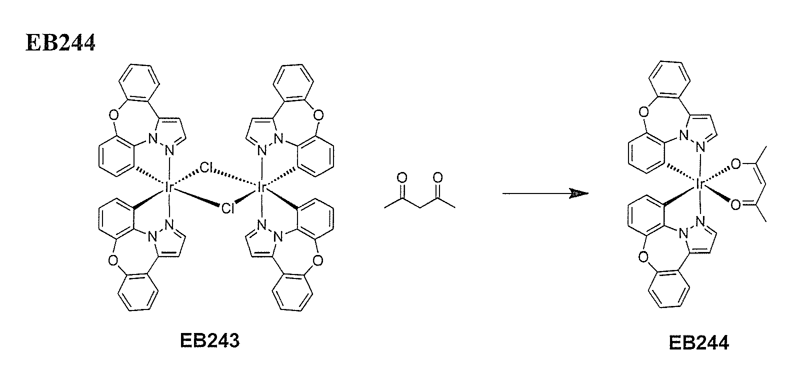

To a suspension of **EB243** (280 mg, 0.20 mmol) in ethoxyethanol (75 mL) was added acetylacetone (100 mg, 1 mmol) and K₂CO₃ (500 mg, 3.6 mmol). The solution was heated at 75 °C for 9 hours under argon. After cooling down to room temperature, water was added and the precipitate filtered off and washed with water and dried. The crude was passed through a pad of silica gel eluting with dichloromethane. **EB244** was obtained as a yellow solid (283 mg, yield 93 %).

¹H NMR (CDCl₃, 400 MHz): δ 7.60 (d, J= 2.4 Hz, 2H); 7.56 (dd, J= 8.0, 1.6 Hz, 2H); 7.33 (dt, J= 8.0, 1.6 Hz, 2H); 7.19 (m, 4H); 6.84 (d, J= 2.4 Hz, 2H); 6.65 (dd, J= 8.0, 7.2 Hz, 2H); 6.60 (dd, J= 8.0, 1.6 Hz, 2H); 6.03 (dd, J= 7.8, 1.6 Hz, 2H); 5.27 (s, 1H); 1.86 (s, 6H).

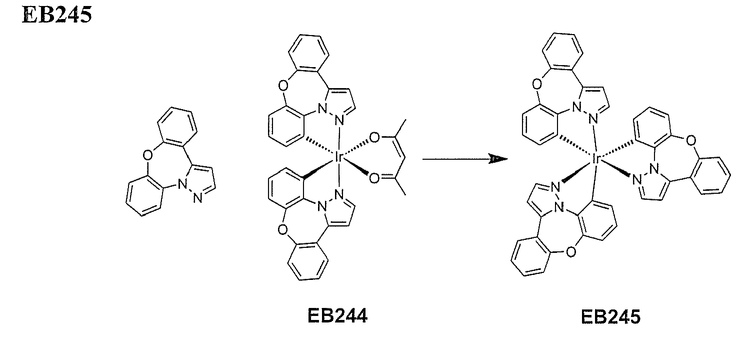

Argon was bubbled into a solution of dibenzo[*b,f*]pyrazolo[1,5-*d*][1,4]oxazepine (160 mg, 0.68 mmol) in glycerol (100 mL) at 80 °C for 1 hour. **EB244** (270 mg, 0.35 mmol) was added as a solid and the suspension heated at 230 °C for 20 hours under argon. After cooling down to room temperature, the solution was diluted with water and extracted with dichloromethane. The organic phase was passed through a pad of silica gel eluting with dichloromethane/hexane. The volume of the solution obtained was reduced to about 15 mL and diethyl ether was added. After leaving in the fridge for 4 hours, the solid was filtrated, washed with Et₂O and dried. **EB245** was obtained as a light yellow solid (200 mg, yield 64 %)

¹H NMR (CDCl₃, 400 MHz): δ 7.46 (dd, J= 8.0, 1.6 Hz, 3H); 7.34 (ddd, J= 8.0, 7.2, 1.6 Hz, 3H); 7.27 (dd, J= 8.0, 1.6 Hz, 3H); 7.16 (dt, J= 7.6, 1.2 Hz, 3H); 7.08 (d, J= 2.4 Hz, 3H); 6.81 (t, J= 8.0 Hz, 3H); 6.76 (dd, J= 8.0, 1.6 Hz, 3H); 6.65 (d, J= 2.4 Hz, 3H); 6.55 (dd, J= 7.2, 1.6 Hz, 3H).

### Example 6 - Preparation of Compound 6 (EB254)

### dibenzo[b,f]imidazo[1,5-d][1,4]oxazepine

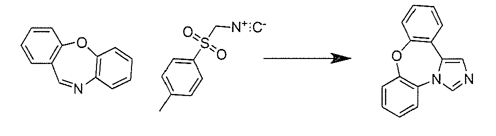

To a solution of dibenzo[b,f][1,4]oxazepine (700 mg, 3.58 mmol) and TOSMIC (1.4 g, 7.17 mmol) in methanol (50 mL) was added potassium carbonate (3.5 g) and the mixture was stirred at room temperature for 3 hours. Water was added and the white precipitate was filtered off and washed with water and methanol (10 mL). The white solid obtained was identified as the imidazoline derivative by ¹H NMR. The filtrate was extracted with dichloromethane and combined with the solid. After evaporation of the solvents, methanol and K₂CO₃ was added and the mixture refluxed for 5 hours. After cooling down to room temperature, water was added and the mixture extracted with dichloromethane. After drying with MgSO₄, the volatiles are removed under vacuum and the compound used directly in the next step without further purification.

¹H NMR (CDCl₃, 400 MHz): δ 7.96 (d, J= 1.2 Hz, 1H); 7.53 (ddd, J= 7.6, 1.6, 0.4 Hz, 1H); 7.40 (m, 3H); 7.31 (m, 3H); 7.21 (m, 2H).

### 2-methyldibenzo[b,f]imidazo[1,5-d][1,4]oxazepin-2-ium iodide

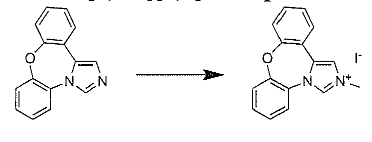

To the crude of dibenzo[*b,f*]imidazo[1,5-*d*][1,4]oxazepine dissolved in acetonitrile was added methyl iodide and the mixture refluxed 6 hours. After cooling down to room temperature, diethyl ether was added and the precipitate filtered off, washed with Et₂O and dried.

¹H NMR (CDCl₃, 400 MHz): δ 10.59 (d, J= 1.2 Hz, 1H); 8.20 (dd, J= 8.0, 1.6 Hz, 1 H); 7.95 (d, J= 2.0 Hz, 1 H); 7.64 (dd, J= 8.0, 1.6 Hz, 1H); 7.49 (m, 2H); 7.43-7.33 (m, 3H); 7.30 (dt, J= 7.6, 1.2 Hz, 1H); 4.38 (s, 3H).

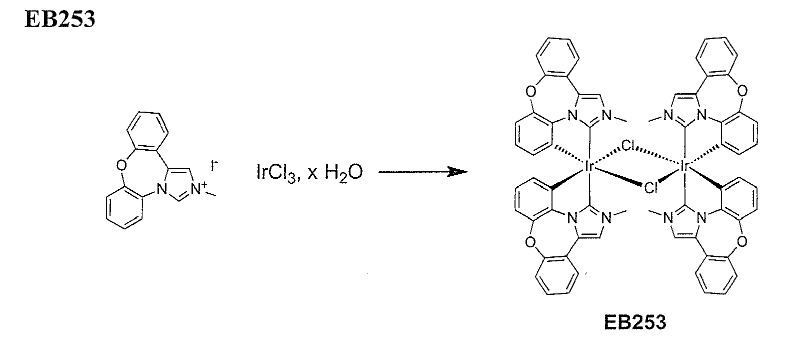

A mixture of IrCl₃, x H₂O (77 mg, 0.22 mmol), 2-methyldibenzo[*b,f*]imidazo[1,5-*d*][1,4]oxazepin-2-ium iodide (305 mg, 0.81 mmol) and silver oxide (395 mg, 1.7 mmol) in ethoxyethanol (30 mL) was degassed by bubbling argon at 70 °C for 20 min and then was heated at 140 °C for 18 hours under argon. The solvent was removed under vacuum. The crude was taken with dichloromethane and passed through a cellite pad eluting with dichloromethane. After reduction of the solvent to about 15 mL, methanol was added and the precipitate filtered off. **EB253** solid (123 mg, yield 77 %).

¹H NMR (CDCl₃, 400 MHz): δ 7.52 (dd, J= 8.0, 1.6 Hz, 4H); 7.37 (s, 4H); 7.20 (dd, J= 8.0, 1.6 Hz, 4H); 7.14 (m, 8H); 6.51 (dd, J= 8.0, 1.6 Hz, 4H); 6.44 (t, J= 7.6 Hz, 4H); 5.93 (dd, J= 7.6, 1.6 Hz, 4H); 4.06 (s, 12H).

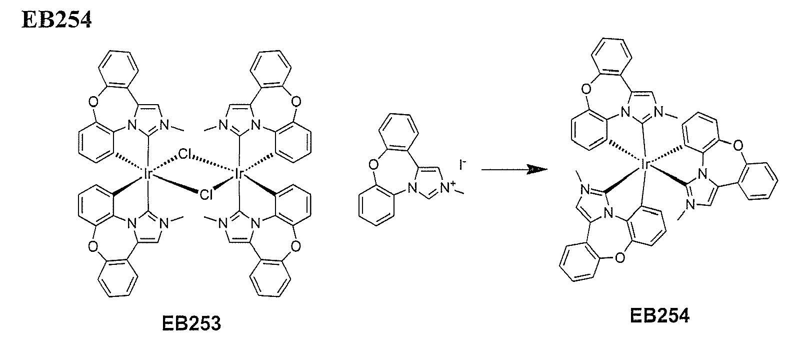

A mixture of **EE253** (110 mg, 0.07 mmol), 2-methyldibenzo[*b,f*]imidazo[1,5-*d*][1,4]oxazepin-2-ium iodide (100 mg, 0.26 mmol) and silver oxide (150 mg, 0.65 mmol) in ethoxyethanol (25 mL) was degassed by bubbling argon at 70 °C for 20 min and then was heated at 140 °C for 48 hours under argon. After cooling down to room temperature, water was added and the precipitate filtered off, washed with water and dried. The crude was purified by silica gel chromatography column using dichloromethane/hexane as eluent. **EB254** was obtained as a white solid as a 1:0.57 mer/fac isomer mixture.

¹H NMR (CDCl₃, 400 MHz), mer isomer: δ 7.38 (dd, J= 7.6, 1.6 Hz, 1H); 7.31 (m, 2H); 7.21 (m, 8H); 7.07 (m, 2H); 7.02 (s, 1H); 7.01 (m, 3H); 6.97 (s, 1H); 6.96 (s, 1H); 6.63 (m, 2H); 6.59 (t, J= 4.0 Hz, 1H); 6.49 (dd, J= 6.0, 2.8 Hz, 1H); 6.33 (dd, J= 5.6, 2.8 Hz, 1H); 3.22 (s, 3H); 3.10 (s, 3H); 3.04 (s, 3H).

¹H NMR (CDCl₃, 400 MHz), fac isomer: δ 7.25 (m, 3H); 7.22 (m, 3H); 6.90 (s, 3H); 6.72 (dd, J= 8.0, 1.6 Hz, 3H); 6.67 (m, 9H); 6.36 (dd, J= 7.2, 1.6 Hz, 3H); 3.16 (s, 9H);

### Example 7 - Preparation of Compound 9 (EB258)

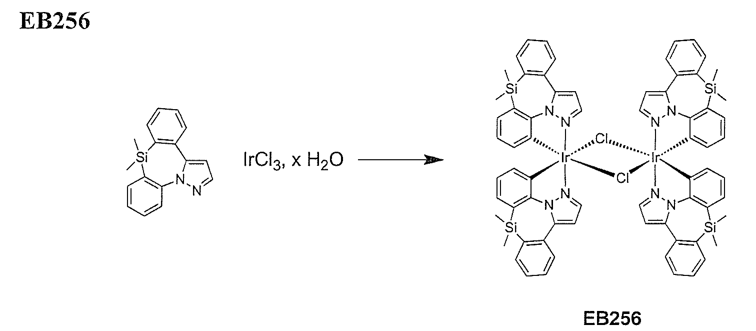

A mixture of IrCl₃, x H₂O (232 mg, 0.65 mmol) and 8,8-dimethyl-8*H-*dibenzo[*b,e*]pyrazolo[5,1-*g*][1,4]azasilepine (400 mg, 1.45 mmol) in water/Ethoxyethanol was heated at 120 °C for 18 hours under argon. After cooling down to room temperature, the mixture is poured into water and the precipitate filtered and washed thoroughly with water and finally with cold methanol (40 mL). **EB256** was obtained as a yellow solid (492 mg, yield 97 %).

¹H NMR (CDCl₃, 400 MHz): δ 8.15 (d, J= 2.0 Hz, 4H); 7.71 (d, J= 7.6 Hz, 4H); 7.67 (d, J= 6.0 Hz, 4H); 7.51 (t, J= 8.0 Hz, 4H); 7.43 (t, J= 7.2 Hz, 4H); 6.90 (d, J= 2.0 Hz, 4H); 6.81 (d, J= 7.2 Hz, 4H); 6.57 (t, J= 7.6 Hz, 4H); 6.00 (d, J= 7.6 Hz, 4H); 0.59 (s, 12H); 0.30 (s, 12H).

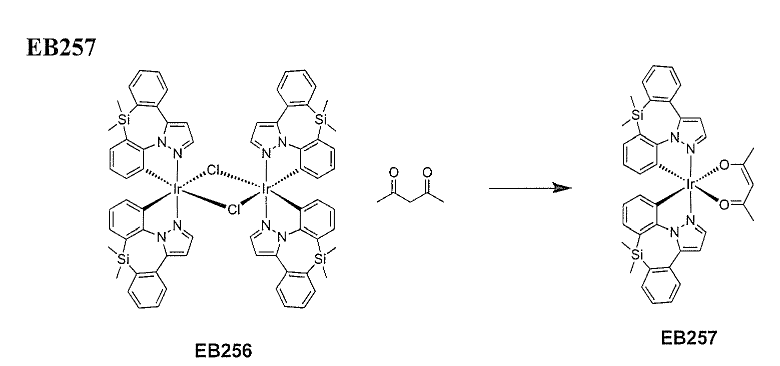

To a solution **of EB256** (300 mg, 0.19 mmol) in dichloromethane (60 mL) was added acetylacetone (50 mg, 0.5 mmol) and tetrabutyl ammonium hydroxide (610 mg, 0.76 mnol). The solution was heated at 40 °C for 12 hours under argon. After cooling down to room temperature, the solution was washed with water and the organic phase was passed through a pad of silica gel eluting with dichloromethane. **EB257** was obtained as a yellow solid (316 mg, yield 98 %).

¹H NMR (CDCl₃, 400 MHz): δ 7.72 (d, J= 2.4 Hz, 2H); 7.66 (dd, J= 7.2, 1.6 Hz, 2H); 7.48 (dt, J= 7.6, 1.6 Hz, 2H); 7.42 (dt, J= 7.2, 1.2 Hz, 2H); 6.89 (d, J= 2.0 Hz, 2H); 6.84 (dd, J= 7.2, 1.2 Hz, 2H); 6.63 (t, J= 7.2 Hz, 2H); 6.35 (dd, J= 7.6, 1.2 Hz, 2H); 5. 26 (s, 1H); 1.80 (s, 6H); 0.40 (s, 6H); 0.39 (s, 6H).

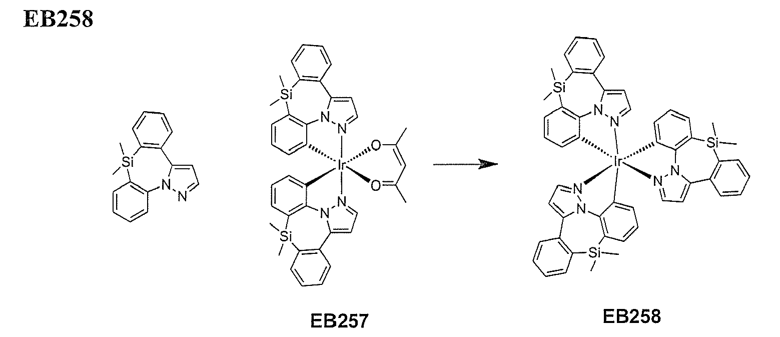

Argon was bubbled into a solution of 8,8-dimethyl-8*H-*dibenzo[*b,e*]pyrazolo[5,1-*g*][1,4]azasilepine (220 mg, 0.79 mmol) in glycerol (60 mL) at 80 °C for 1 hour. **EB257** (184 mg, 0.22 mmol) was added as a solid and the suspension heated at 200 °C for 20 hours under argon. After cooling down to room temperature, the solution was diluted with water and extracted with dichloromethane. The organic phase was passed through a pad of silica gel eluting with dichloromethane. The volume of the solution obtained was reduced to about 15 mL and diethyl ether was added. After leaving in the fridge for 4 hours, the solid was filtrated, washed with Et₂O and dried. **EB258** was obtained as a yellow solid (153 mg, yield 69 %).

¹H NMR (CDCl₃, 400 MHz): δ 7.63 (dd, J= 7.2, 2.4 Hz, 3H); 7.50 (dd, J= 7.2, 2.0 Hz, 3H); 7.40 (m, 6 H); 7.06 (d, J= 2.0 Hz, 3H); 6.97 (d, J= 7.2 Hz, 3H); 6.75 (t, J= 7.2 Hz, 3H); 6.65 (d, J= 7.2 Hz, 3H); 6.61 (d, J= 1.6 Hz, 3H); 0.54 (s, 9H); 0.21 (s, 9H).

### Example 8 - Preparation of Compound 8 (EB249)

### 2,3-dimethyldibenzo[b,f]imidazo[1,2d][1,4]thiazepine

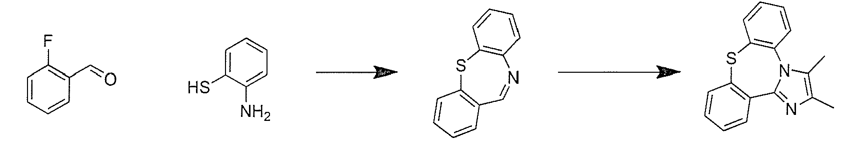

To a solution of 2-aminothiophenol (3.54 g) in DMF (85 mL) was added 2-fluorobenzaldehyde (3.52 g) and K₂CO₃ (3.24 g). The mixture was heated at 100 °C for 20 hours. After cooling down to room temperature, water was added and extracted with diethyl ether. The organic phase was washed with water and brine and dried over MgSO₄. After removal of volatiles under vacuum, the crude is purified by column chromatography on silica gel using CH₂Cl₂/Et₂O as eluent. The compound is obtained as a light brown soft solid and used without further purification.

A solution of dibenzo[*b,f*][1,4]thiazepine (2.23 g) and 2,3-butanedione monoxime (1.01 g) in acetic acid (100 mL) was heated at 120 °C for 4 hours. After cooling down at room temperature, zinc powder (2 grams) was added and the mixture further heated at 120 °C for 1 hour and left at room temperature overnight. The suspension is then filtered and filtrate is reduced to about 20 mL. Water was added (about 100 mL) and aqueous KOH was added up to pH ~ 8. The mixture was extracted with dichloromethane and the crude obtained purified by column chromatography using CH₂Cl₂/Et₂O as eluent. The ligand was obtained as a brown waxy solid (1.89 g)

¹H NMR (CDCl₃, 400 MHz): δ 7.86 (dd, J= 7.6, 2.0 Hz, 1H); 7.70 (dd, J=8.0, 1.6 Hz, 1H); 7.52 (dd, J= 7.6, 2.0 Hz, 1H); 7.38-7.22 (m, 4H); 7.20 (dd, J=8.0, 1.6 Hz, 1H);2.32 (s, 3H); 2.21 (s, 3H).

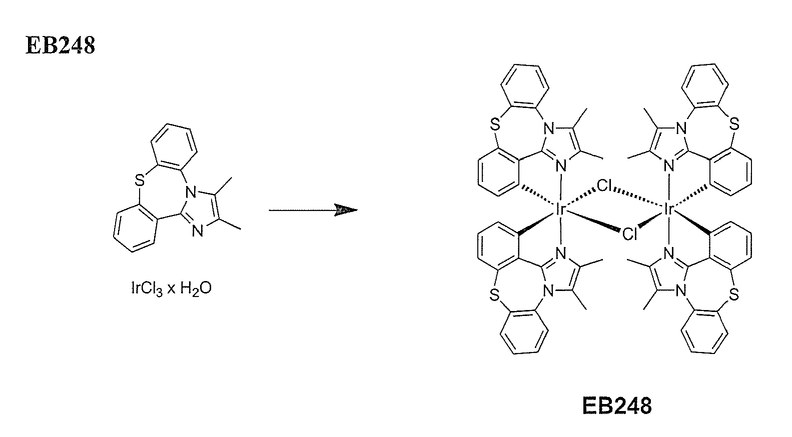

A mixture of IrCl₃, x H₂O (530 mg) and 2,3-dimethyldibenzo[*b,f*]imidazo[1,2*d*][1,4]thiazepine (0.87 g) in water/Ethoxyethanol was heated at 130 °C for 18 hours under argon. After cooling down to room temperature, the mixture is poured into water and the precipitate filtered and washed thoroughly with water and finally with cold methanol (40 mL). **EB248** was obtained as a orange solid.

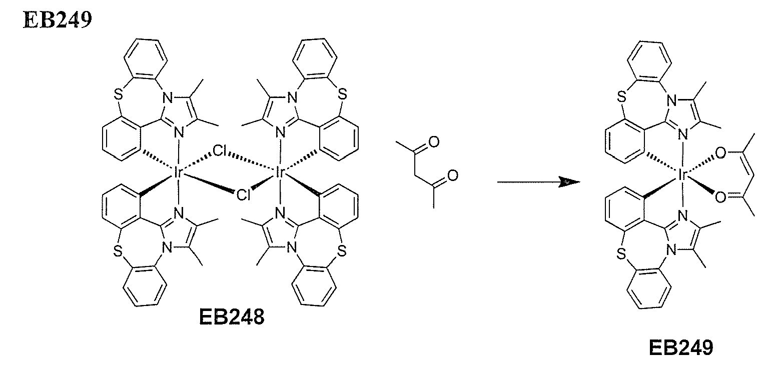

To a solution of **EB249** (400 mg) in dichloromethane (80 mL) was added acetylacetone (100 mg) and tetrabutyl ammonium hydroxide (600 mg). The solution was heated at 40 °C overnight under argon. After cooling down to room temperature, the solution was washed with water and the organic phase was passed through a pad of silica gel eluting with dichloromethane. **EB249** was obtained as a yellow solid.

¹H NMR (CDCl₃, 400 MHz): δ 7.15 (dd, J= 8.0, 2.0 Hz, 2H); 7.12 (dd, J= 8.0, 2.0 Hz, 2H); 7.06 (dt, J= 7.6, 2.0 Hz, 2H); 7.02 (dt, J= 7.6, 1.6 Hz, 2H); 6.78 (t, J= 8.0 Hz, 2H); 6.51 (dd, J= 8.0, 0.8 Hz, 2H); 6.32 (dd, J= 7.2, 0.8 Hz, 2H); 5.33 (s, 1H); 2.53 (s, 6H); 2.22 (s, 6H); 1.78 (s, 6H).

### Example 9 - Preparation of Compound 7 (EB261)

### 11-fluoro-2,3,7-trimethylbenzo[b]imidazo[1,2-d]pyrido[3,2-f][1,4]oxazepine

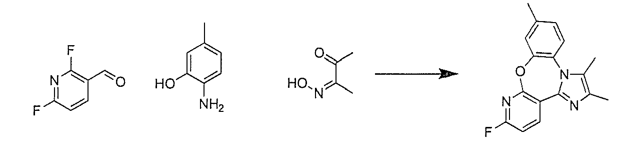

2,6-difluoronicotinaldehyde was obtained as described in M. Schlosser and T. Rausis, Eur. J Org. Chem. 2004, 1018.

A mixture of 2,6-difluoronicotinaldehyde (2 g, 13.9 mmol), 2-amino-5-methylphenol (1.7 g, 13.8 mmol) and 2,3-butanedione monoxime (1.065 g, 10.5 mnol) in acetic acid (120 mL) was heated at 120 °C for 1.5 hours. After cooling down to room temperature, zinc powder (2 g) was added and the mixture heated one hour at 120 °C and left overnight at room temperature. The suspension is then filtered and filtrate is reduced to about 20 mL. Water was added (about 100 mL) and aqueous KOH was added up to pH ~ 8. The mixture was extracted with dichloromethane and the crude obtained purified by column chromatography using CH₂Cl₂/Et₂O as eluent. The ligand was obtained as a beige solid (2.14 g, yield 68 %)

¹H NMR (CDCl₃, 400 MHz): δ 8.28 (t, J= 8.0 Hz, 1H); 7.25 (d, J= 1.6 Hz, 1H); 7.09 (d, J= 8.4 Hz, 1H); 6.99 (ddd, J= 8.0, 2.0, 0.8 Hz, 1H); 6.79 (dd, J= 8.4, 2.8 Hz, 1H); 2.27 (s, 3H); 2.24 (d, J= 0.8 Hz, 3H); 2.19 (d, J= 0.8 Hz, 3H).

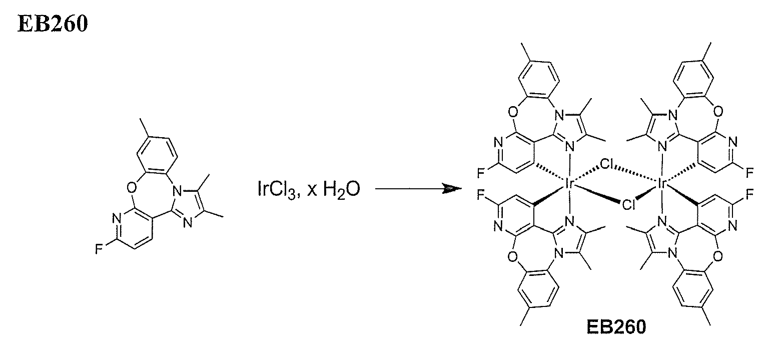

A mixture of IrCl₃, x H₂O (110 mg, 0.31 mmol) and 11-fluoro-2,3,7-trimethylbenzo[b]imidazo[1,2-d]pyrido[3,2-f][1,4]oxazepine (202 mg, 0.68 mmol) in water/Ethoxyethanol was heated at 120 °C for 18 hours under argon. After cooling down to room temperature, the mixture is poured into water and the precipitate filtered and washed thoroughly with water and finally with cold methanol (40 mL). **EB260** was obtained as a yellow solid (328 mg, yield 64 %).

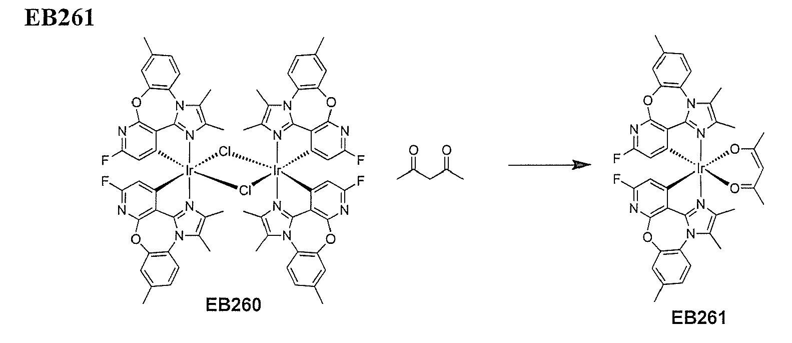

To a solution **of EB260** (200 mg, 0.12 mmol) in dichloromethane (60 mL) was added acetylacetone (50 mg, 0.5 mmol) and tetrabutyl ammonium hydroxide (400 mg, 0.5 mmol). The solution was heated at 40 °C for 12 hours under argon. The solvents were removed under vacuum and methanol was added to induce precipitation. After filtration and washing with methanol, **EB261** was obtained as a yellow solid (149 mg, yield 70 %).

¹H NMR (CDCl₃, 400 MHz): δ 7.30 (dd, J= 1.6, 0.8 Hz, 2H); 7.22 (d, J= 8.4 Hz, 2H); 7.07 (ddd, J= 8.4, 2.0, 0.8 Hz, 2H); 5.81 (d, J= 1.2 Hz, 2H); 5.33 (s, 1H); 2.50 (d, J= 0.4 Hz, 6H); 2.36 (s, 6H); 2.15 (d, J= 0.4 Hz, 6H); 1.78 (s, 6H).

### Example 10 - Preparation of Compound 10 (EB277)

### Synthesis of 6,7-dimethyl-9H-dibenzo[c,e]imidazo[1,2-a]azepine

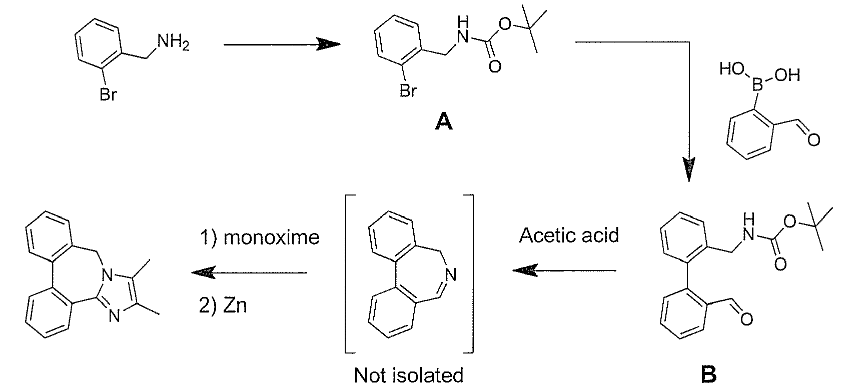

2-Bromo-benzyl amine is stirred at room temperature for three hours with an excess of di-tert-butyl dicarbonate in dichloromethane in presence of triethyl amine. The solution is then washed with 2M aqueous HCl and then with water. The organic part is dried with MgSO4 and volatiles evaporated yielding quantitatively a colorless visquous oil of **A** which crystallized to a white solid on standing.

**A** (1.5 g) was mixed with 2-formylboronic acid (0.74 g) and K₂CO₃ (2 g) in DMF (50 mL). The suspension was degassed with argon and tetrakis (triphenylphosphine) palladium (200 mg) was added. The mixture was heated at 90 °C overnight under argon. After cooling to room temperature, it was extracted with diethylether and the organic phase washed with water and brine and dried with MgSO₄. The crude was broadly purified pas filtration on a silica gel pad eluting with dichloromethane/diethylether (2% volume) yielding 1.8g of yellow oil which solidify to pale brownish solid on standing. This solid contains mainly **B** with deprotected and cyclized molecule as side product. As those side products are intermediates in the next step, it is used without further purification.

**B** (1.11 g) was dissolved in acetic acid and stirred at 50 °C for 2 hours. Butane-2-one monoxime (400 mg) was added as solid and the mixture heated at 120 °C for 3 hours. After cooling to room temperature, powdered zinc (2 grams) was added by portion and the mixture heated at 120 °C for two hours and left at room temperature overnight. The suspension was filtered and the filtrate reduced under vacuum. Aqueous sodium hydroxide was added and the mixture extract with dichloromethane and the organic phase dried with MgSO₄. Purification was achieved by chromatography on silica gel using dichloromethane/diethylether 100/0 to 50/50 in volume. 6,7-dimethyl-9*H-*dibenzo[*c,e*]imidazo[1,2-*a*]azepine was obtained as a colorless oil crystallizing to white solid was obtained (0.89 g).

¹H NMR (CDCl₃, 400 MHz): δ 8.08 (m, 1H); 7.65 (m, 1H); 7.57-7.49 (m, 3H); 7.41 (m, 1H); 7.36-7.33 (m, 2H); 4.80 (d; J=14 Hz, 1H); 4.63 (d; J=14 Hz, 1H); 2.80 (d, J=0.4 Hz, 3H); 2.24 (d, J=0.4Hz, 3H).

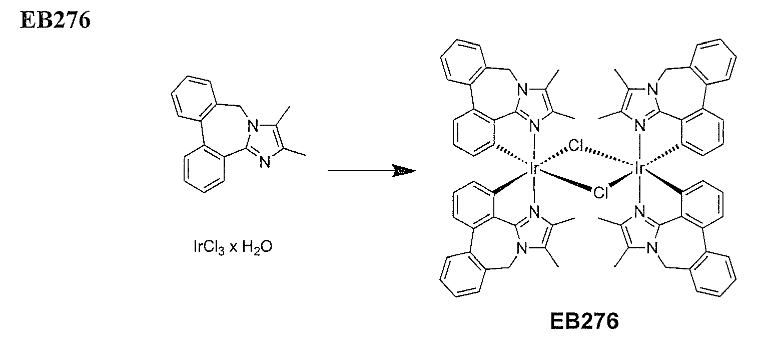

A mixture of IrCl₃, x H₂O (150 mg) and 6,7-dimethyl-9*H-*dibenzo[*c,e*]imidazo[1,2-*a*]azepine (300 mg, 0.68 mmol) in ethoxyethanol was heated at 90 °C for 30 hours under argon. After cooling down to room temperature, the mixture is poured into water and the precipitate filtered and washed thoroughly with water and finally shortly with cold methanol. **EB276** was obtained as a yellow solid (181 mg).

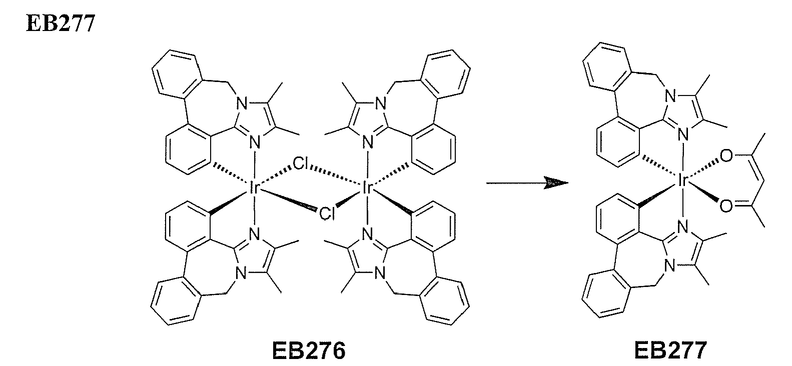

To a solution of **EB276** (100 mg) in dichloromethane (50 mL) was added acetylacetone (100 mg) and tetrabutyl ammonium hydroxide (200 mg, 0.5 mmol). The solution was heated at 40 °C for 12 hours under argon. The solvents were removed under vacuum and the crude filtered on a pad of silica gel eluted with dichloromethane. **EB277** was obtained as a yellow solid (93 mg,).

¹H NMR (CDCl₃, 400 MHz): δ 7.59 (d, J=8 Hz, 4H); 7.42 (m, 4H); 7.34 (dt, J=7.2, 0.8 Hz, 2H); 7.12 (d, J=7.6Hz, 2H); 6.45 (t, J= 7.6 Hz, 2H); 6.28 (dd, J= 0.8, 7.6 Hz, 2H); 5.21 (s, 1H); 4.95 (d, J=13.6 Hz, 2H); 4.90 (d, J=13.6 Hz, 2H); 2.41 (s, 6H); 2.17 (s, 6H); 1.70 (s, 6H).

### Embodiment 1

The second complex, Compound 1 based on 7-membered ring fused ligand (7-MFL) using oxygen as bridge due to straightforward synthesis was prepared.

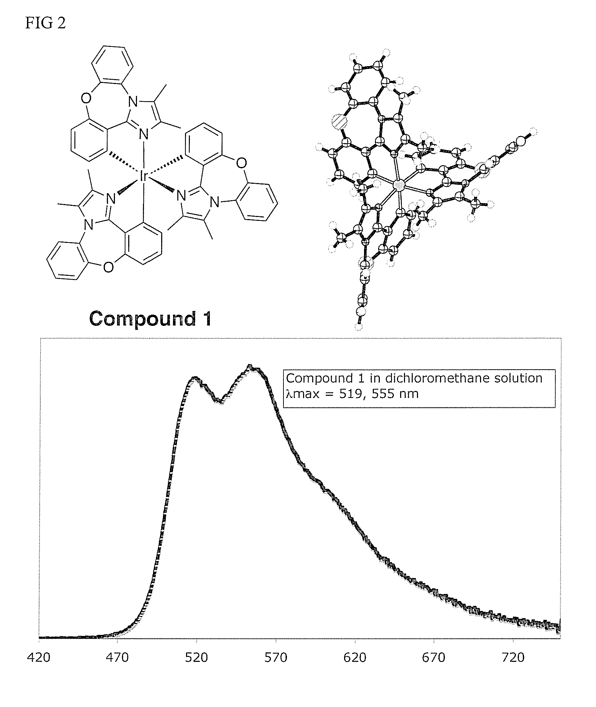

FIG. 2 shows chemical structure, X-ray crystal structure and emission of CH₂Cl₂ solution of Compound 1. Compound 1 has bright and broad green emission. In addition, this is a very soluble complex in common organic solvents, where Comparative Compound 1 shows low solubility. Device fabrication is conducted as follows:
- A HIL based on polyethylenedioxythiophene:polystyrene sulfonate (PEDOT:PSS purchased form HC Stack) is deposited by spin coating on indium tin oxide (ITO) coated glass substrates to a thickness of 60 nm. The obtained film is dried on a hot plate at 200 °C for 10 min.
- The EML contains PVK (polyvinylcarbazole) as hole transporter matrix, PDB (2-(4-Biphenylyl)-5-(4-tert-butylphenyl)-1,3,4-oxadiazole) as electron transporter matrix in 70:30 ratio and 1 to 10 wt% Compound 1 as emitter.

The total solid content is 1.5 wt% in toluene.
- Such formulation is deposited on top of the HIL by spincoating to a thickness of 60 nm and subsequently dried on a hot plate at 80 °C for 10 min.
- A 30 nm thick ETL, namely 2,2',2"-(1,3,5-benzinetriyl)-tris(1-phenyl-1-H-benzimidazole) (TPBi, purchased from Lumtec) is deposited by vacuum deposition onto the EML at a rate of 2 Å/s.
- Finally, cathode layers comprising 1 nm of LiF and 100 nm of Al are deposited by thermal evaporation at a rate of 0.1 and 2 Å/s respectively.

Electronic and photometric characterizations are done with a Hamamatsu C9920-12 measurement system coupled to a Keithley 2400 source measure unit. All device fabrication and characterization steps after PEDOT:PSS spinning are carried out in an inert atmosphere.

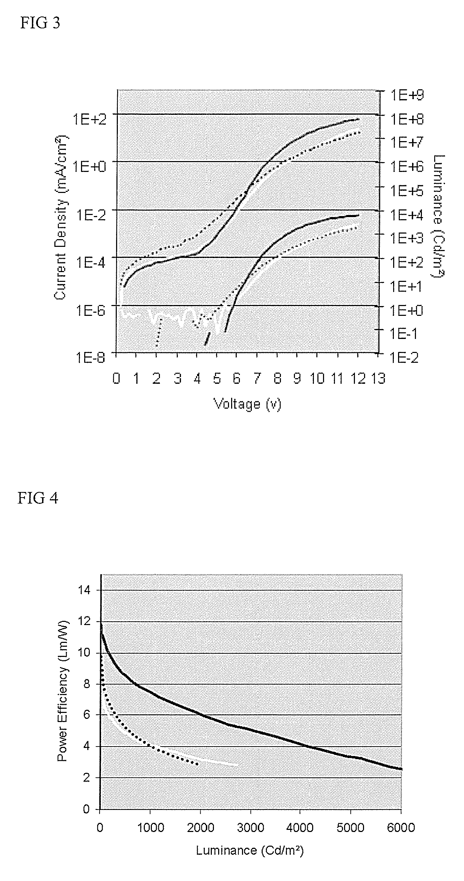

FIG. 3 shows the IVL characteristics of the different devices prepared with Compound 1, while FIG. 4 shows the luminous efficiency of these devices as a function of the luminance.

The devices performances measured at 1,000 Cd/m² are summarized in the table below.

| | Von | EQE, % | Lm/W | Cd/A | CIE coordinates (x, y) |
|---|---|---|---|---|---|
| 1 wt % Compound 1 | 8.6 | 6.1 | 7.5 | 20.5 | (0.36, 0.59) |
| 5 wt % Compound 1 | 10.8 | 4.3 | 4.2 | 14.6 | (0.37, 0.59) |
| 10 wt % Compound 1 | 10.6 | 4.2 | 4.1 | 13.8 | (0.37, 0.59) |

### Embodiment 2

The known approach, namely introducing various substituents on the cyclometallated phenyl for tuning the emitted color, was used.

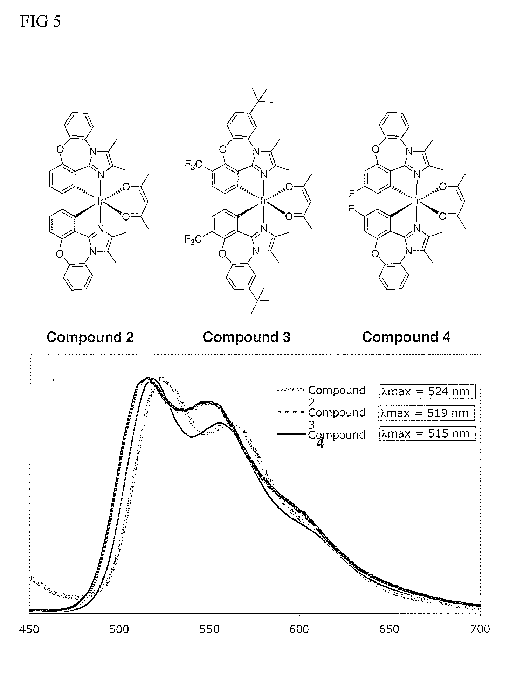

FIG. 5 shows chemical structure and emission of CH₂Cl₂ solution of Compound 2, Compound 3 and Compound 4.

### Embodiment 3

The modified neutral ring, going from imidazole to pyrazole and to carbene, was prepared.

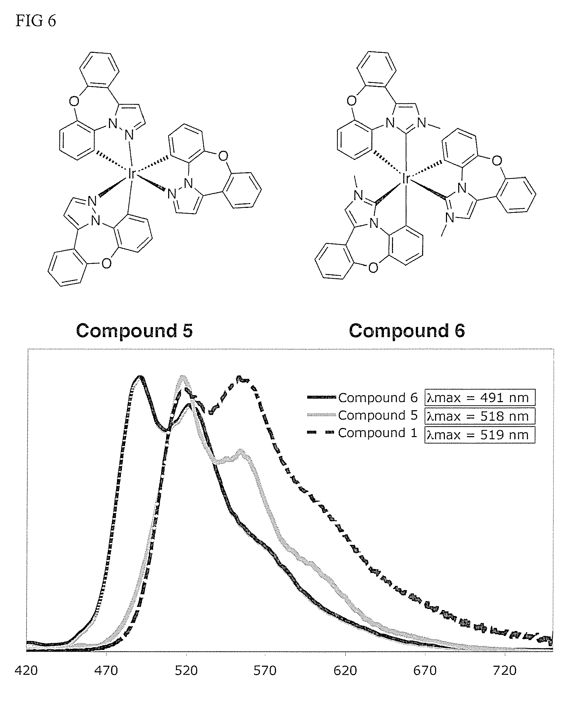

FIG. 6 shows chemical structure and emission of CH₂Cl₂ solution of Compound 1, Compound 5 and Compound 6. The carbene complex Compound 6 has been obtained as a mixture of facial and meridional isomer.

### Embodiment 4

To tune the emitted color, cyclometallated phenyl ring of the complex of

Example 2 is changed to fluoropyridine.

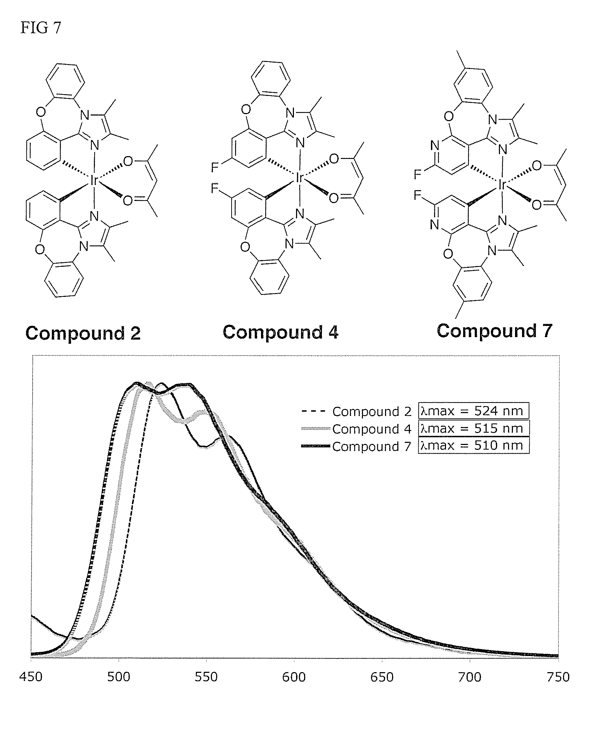

FIG. 7 shows chemical structure and emission of CH₂Cl₂ solution of Compound 2, Compound 4 and Compound 7.

### Embodiment 5

Complexes which have modified bridge, first by replacing the oxygen with sulfur and then by silicon, were prepared in order to show further tuning of the emitted color.

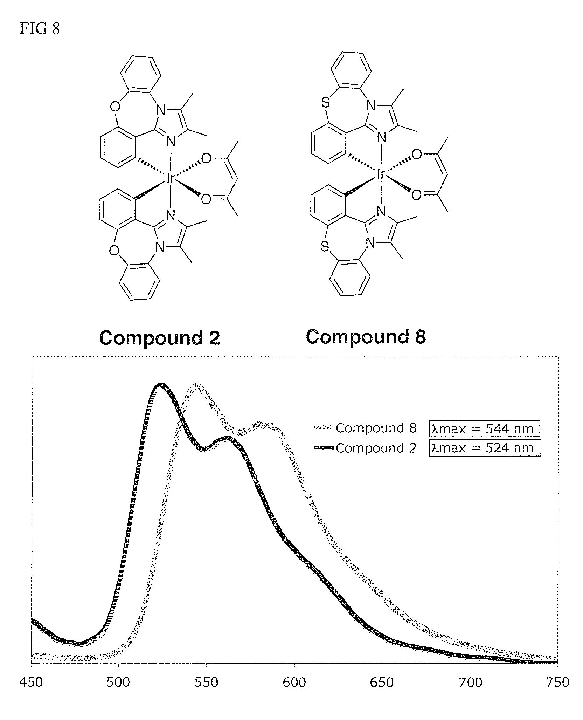

FIG. 8 shows chemical structure and emission of CH₂Cl₂ solution of Compound 2 and Compound 8 replacing the oxygen with sulfur.

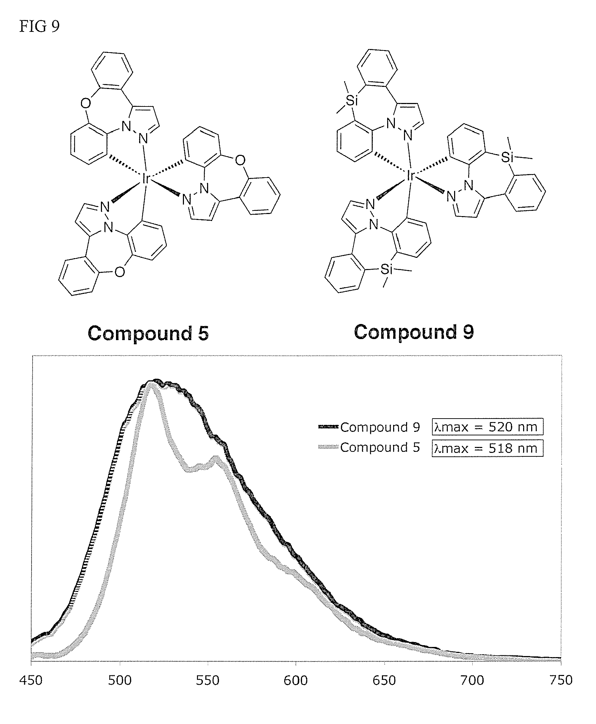

FIG. 9 shows chemical structure and emission of CH₂Cl₂ solution of Compound 5 and Compound 9 replacing the oxygen with a silicium.

### Embodiment 6

Complex with a ligand having an "inverse structure" was prepared in order to show the extended possibility of design of the ligand.

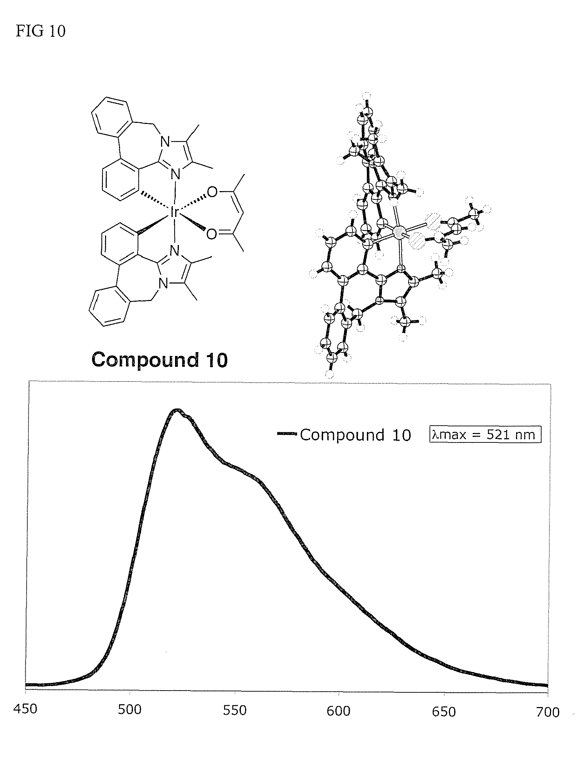

FIG. 10 shows chemical structure and emission of CH₂Cl₂ solution of Compound 10.

It will be apparent to those skilled in the art that various modifications and variations can be made to the present invention without departing from the spirit and scope of the invention. Thus, it is intended that the present disclosure covers the modifications and variations of this invention, provided they come within the scope of the appended claims and their equivalents.

## Claims

1. An organometallic complex having a partial structure represented by the following formula (I-0) or a tautomer thereof: 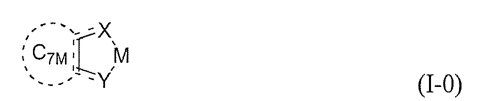 wherein M is a metal atom, preferably a transition metal having an atomic number of at least 20, preferably of at least 40, preferably of the groups 7 to 12, more preferably iridium or platinum, most preferably iridium; X and Y are atoms coordinated to M, preferably from the groups 13 to 16, more preferably from C, N, O, S, Si, or P, most preferably from C or N; C_{7M} is a seven or more membered ring which may be aromatic, non aromatic, partially aromatic, free of hetero atom or containing at least one hetero atom, said seven or more membered ring having no atom belonging to the seven member ring directly coordinated to the metal. wherein the ring C_{7M} may be part of a larger ligand which may contain additional fused ring, such ligand being preferably a bidentate, tridentate, tetradentate, pentadentate or hexadentate ligand, more preferably a bidentate or tiidentate, most preferably a bidentate ligand.

2. The organometallic complex according to claim 1, comprising one metal atom **M** and at least one ligand **P*** represented by the formula (I) or formula (I') below : 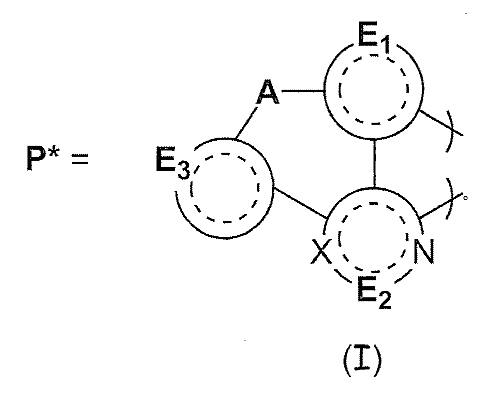 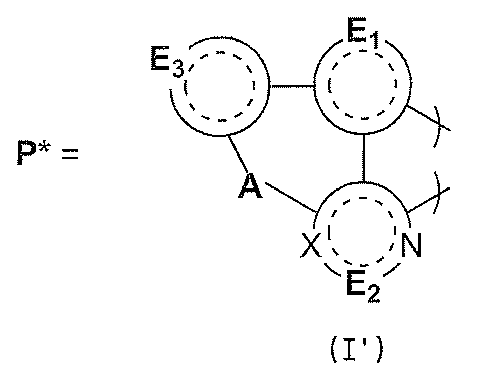 wherein :
- **E₁** represents an aromatic or heteroaromatic ring, preferably 5- or 6-membered, optionally condensed with an additional aromatic moiety or another non-aromatic cycle, said ring having optionally one or more substituents and coordinating **M** via a sp² hybridized carbon;
- **E₂** represents an aromatic or heteroaromatic ring, preferably comprising at least one nitrogen atom and optionally one or more additional hetero atom X, preferably 5-membered, optionally condensed with an additional aromatic moiety or an other non-aromatic cycle, said ring having optionally one or more substituents and coordinating **M** via a sp² hybridized carbon or via a sp² hybridized nitrogen, preferably via a sp² hybridized nitrogen;
- **E₃** represents an aromatic or heteroaromatic ring, preferably 5- or 6-membered, optionally condensed with additional aromatic moiety or other non-aromatic cycle, said ring having optionally one or more substituents;
- **A** represents an organic or hetero organic bridging group, formed by at least one atom bonding **E₁** with **E₃** or **E₂** with **E₃** and forming with **E₁**, **E₂** and **E₃** a central ring, said central ring is 7- or more membered, preferably 7- to 9-membered, more preferably 7-membered.

3. The organometallic complex according to claim 2, wherein the metal **M** is a transition metal from the group IB, IIB, IIIB, IVB, VB, VIB, VIIB or VIII, preferably from the group VIII, more preferably Os, Ir or Pt, and the bidentate ligand **P*** is represented by one of the formulas (II) to (VI") below: 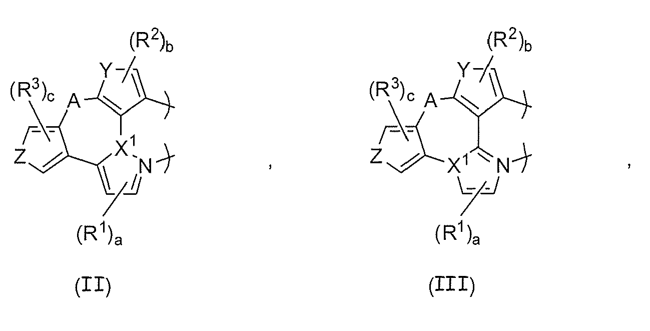 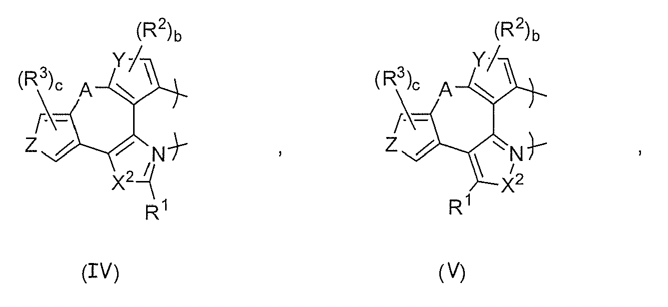 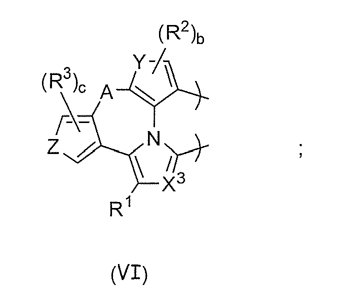 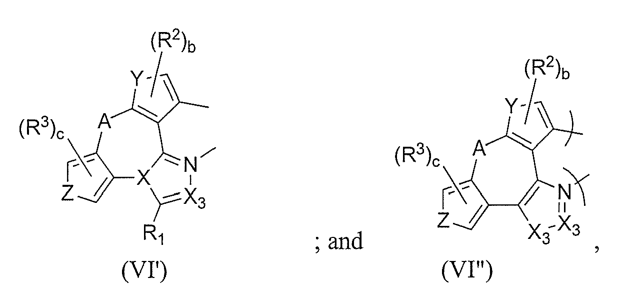 wherein
- **A** has the same meaning as defined above;
- **X¹** is C or N, preferably X¹ is N;
- **X²** is selected from the group consisting of C-H, C-R', N-H and N-R, preferably **X²** is N-H or N-R, more preferably **X²** is N-R;
- **X³** is selected from the group consisting of N, N-H and N-R', preferably **X³** is N-R;
- **Y** and **Z** are the same or different at each occurrence and are selected from the group consisting of O, S, Se, N-H, N-R, -CH=CH-, -CR'=CH-, -CR'=CR'-, -CH=N-, -CR'=N-, preferably Y and Z are selected from the group consisting of -CH=CH- -CR'=CH-, -CR'=CR'-or -CH=N-;
- **R** is the same or different at each occurrence and is selected from the group consisting of straight or branched alkyl having from 1 to 20 carbon atoms, cyclic alkyl having from 3 to 20 carbon atoms, straight or branched heteroalkyl having from 1 to 20 carbon atoms, aryl having from 4 to 14 carbon atoms, heteroaryl having from 4 to 14 carbon atoms that may be substituted by one or more non aromatic radicals;
- **R¹, R²**, **R³** and **R'** are the same or different at each occurrence and is selected from the group consisting of -H, -F, -Cl, -Br, -CN, -NO₂, -CF₃, straight or branched alkyl having from 1 to 20 carbon atoms, cyclic alkyl having from 3 to 20 carbon atoms, straight or branched heteroalkyl having from 1 to 20 carbon atoms, aryl having from 4 to 14 carbon atoms, heteroaryl having from 4 to 14 carbon atoms that may be substituted by one or more non aromatic radicals; **R¹, R²**, **R³** and **R'** can form additional fused ring system with the ring moiety on which they are grafted and/or with the bridging group **A.**
- **a** and **c** are the same or different at each occurrence and represent an integer from 0 to 2;
- **b** represents an integer from 0 to 1.

4. The organometallic complex according to any of claims 1 to 3 wherein the metal **M** is Ir.

5. The organometallic complex according to any of claims 2 to 4 wherein:
**A** is selected from the group consisting of O, S, Se, C=O, 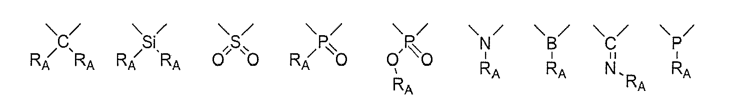 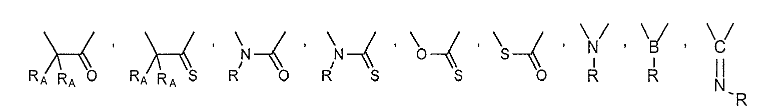 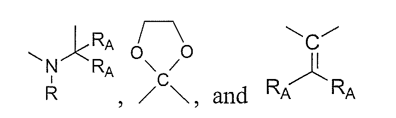 wherein
- **R** has the same meaning as defined above for formulae (I) and (1'); **R** can form additional fused ring system with a neighboring ring moiety;
- **R_{A}** is the same or different at each occurrence and is selected from the group consisting of -H, -F, -Cl, -Br, -CN, NO₂, straight or branched alkyl having from 1 to 20 carbon atoms, cyclic alkyl having from 1 to 20 carbon atoms, aryl having from 4 to 14 carbon atoms, straight or branched heteroalkyl having from 1 to 20 carbon atoms which may be substituted by one or more non aromatic radicals, preferably **R_{A}** is selected from the group of alkyl or aryl having from 1 to 6 carbon atoms; more preferably **R_{A}** is selected from the group of methyl, ethyl, n-propyl, i-propyl, n-butyl cycloalkyl or polycycloalkyl; **R_{A}** can form additional fused ring system with a neighboring ring moiety;
a straight or branched alkyl having from 1 to 20 carbon atoms, a cyclic alkyl having from 1 to 20 carbon atoms, an aryl having from 4 to 14 carbon atoms,
straight or branched heteroalkyl having from 1 to 20 carbon atoms which may be substituted by one or more non aromatic radical, preferably A is selected from
the group consisting of O, S, Se, C=O, 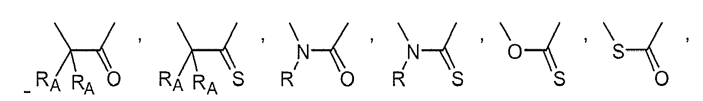 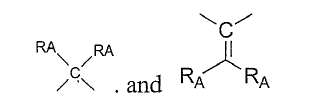 more preferably **A** is selected from the group consisting of O, S, -N-H, -N-R, -C(CH₃)₂ , C=C(H)R or C=O.

6. The organometallic complex according to any of claims 2 to 5 wherein said complex is bis-homoleptic and comprises two bidentate principal ligands **P*** as defined above and one ancillary ligand wherein said ligand is a bidentate ancillary ligand, preferably aceto acetonate type or picolinate type, more preferably aceto acetonate type.

7. The organometallic complex according to claim 6 wherein said complex is represented by the formula (VII) below: 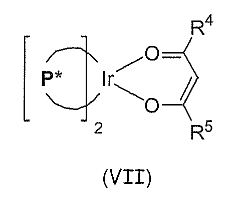 wherein:
- **P*** has the same meaning as defined above;
- **R⁴** and **R⁵** are the same or different at each occurrence and are independently selected from the group consisting of straight or branched alkyl having from 1 to 20 carbon atoms, cyclic alkyl having from 1 to 20 carbon atoms, aryl having from 4 to 14 carbon atoms, straight or branched hetero alkyl having from 1 to 20 carbon atoms which may be substituted by one or more non aromatic radicals, preferably **R⁴** and **R⁵** are independently selected from the group of alkyl or aryl having from 1 to 6 carbon atoms; more preferably **R⁴** and **R⁵** are selected from the groups of methyl, ethyl, n-propyl, i-propyl, n-butyl, cycloalkyl and polycycloalkyl.

8. The organometallic complex according to claim 7 and corresponding to one of the formulas (VIII) to (XII") below:

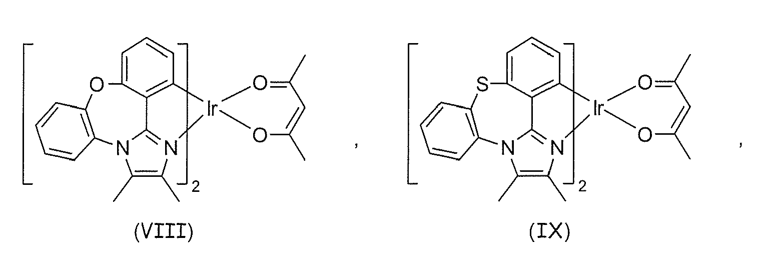

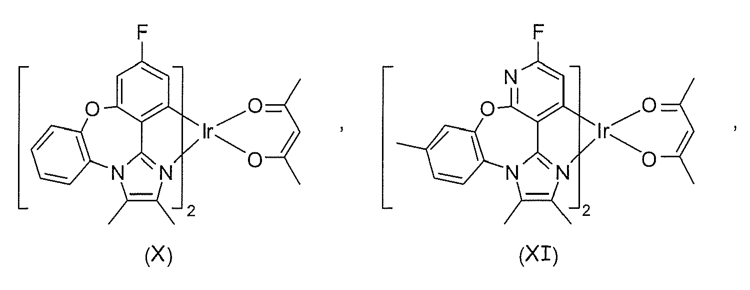

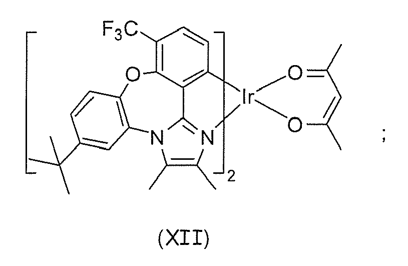

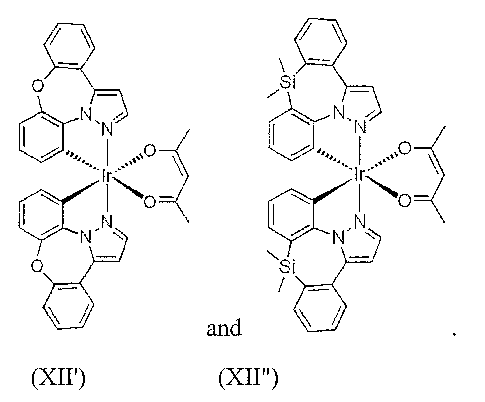

9. The organometallic complex according to any of claims 2 to 5 wherein said complex is tris-homoleptic and comprises three bidentate principal ligands **P*** as defined above.

10. The organometallic complex according to claim 9 and corresponding to one of the formulas (XIII) to (XVI) below:

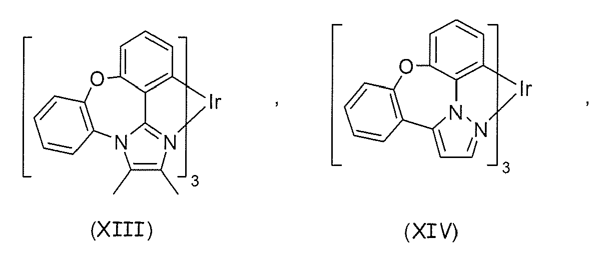

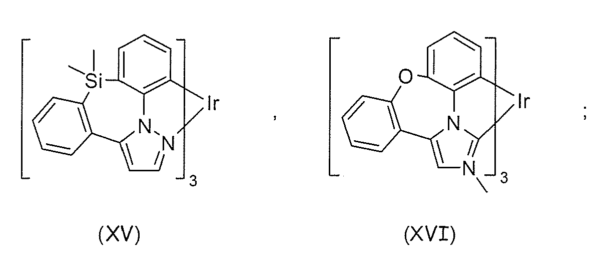

11. The organometallic complex according to claim 5, wherein said complex is shown as below: 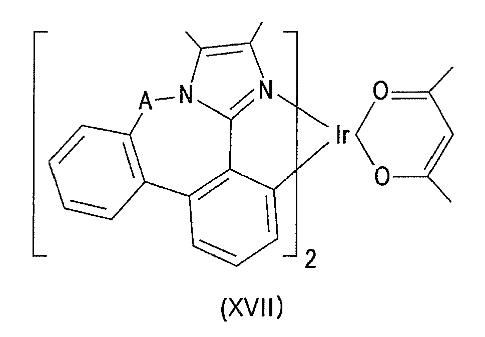 wherein, A is the same as defined in claim 5, the complex being preferably as shown in formula (XVIII)

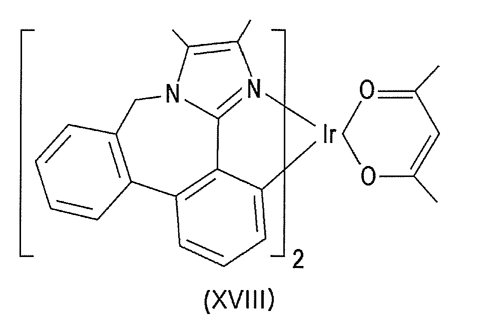

12. The use of an organometallic complex according to any of claims 1 to 11 as light emitting material or dopant in the emissive layer of an Organic Light Emitting Device.

13. The use of any organometallic complex according to any of claims 1 to 11 as dopant in a conductive or functional layer of an Organic Light Emitting Device.

14. An Organic Light Emitting Device comprising an emissive layer, said emissive layer comprising an organometallic complex according to any of claims 1 to 11, wherein said complex is used as phosphorescent light emitting material.

15. An Organic Light Emitting Device comprising at least one functional layer wherein an organometallic complex according to any of claims 1 to 11 is used as dopant material.
